# EUROPÄISCHE PATENTANMELDUNG

(11) **EP 3 666 782 A1**
(43) Veröffentlichungstag der Anmeldung: **17.06.2020**
(21) Anmeldenummer: 18211763.0
(22) Anmeldetag: 11.12.2018
(51) Int. Cl.: C07F 9/50, C07F 9/52, C07F 5/06, C23C 18/10

(54) **LITHIUMALKYLALUMINATE, VERWENDUNG EINES LITHIUMALKYLALUMINATS ALS TRANSFERREAGENZ, VERFAHREN ZUR ÜBERTRAGUNG WENIGSTENS EINES RESTES R, VERBINDUNGEN E(X)Q-PRP UND DEREN VERWENDUNG, SUBSTRAT UND VERFAHREN ZUR HERSTELLUNG VON LITHIUMALKYLALUMINATEN**

(71) Anmelder: UMICORE AG & CO. KG, 63457 Hanau-Wolfgang (DE)
(72) Erfinder: SUNDERMEYER, Joerg, 35041 Marburg (DE); PULZ, Susanne, 35037 Marburg (DE)
(74) Vertreter: Clauswitz, Kai-Uwe Wolfram

(57) **Zusammenfassung**

Die Erfindung betrifft Lithiumalkylaluminate gemäß der allgemeinen Formel Li[AlR₄] sowie ein Verfahren zu deren Herstellung, ausgehend von LiAlH₄ und RLi in einem aprotischen Lösungsmittel. Gegenstand der Erfindung sind zudem Verbindungen gemäß der allgemeinen Formel Li[AlR₄], erhältlich nach dem beanspruchten Verfahren, sowie deren Verwendung. Die Erfindung betrifft weiterhin die Verwendung eines Lithiumalkylaluminats Li[AlR₄] als Transferreagenz zur Übertragung wenigstens eines Restes R auf ein Element- oder Metallhalogenid sowie ein Verfahren zur Übertragung wenigstens eines Restes R auf eine Verbindung E(X)_{q} zur Herstellung einer Verbindung gemäß der allgemeinen Formel E(X)_{q-p}Rₚ. Dabei ist E = Aluminium, Gallium, Indium, Thallium, Germanium, Zinn, Blei, Antimon, Bismut, Zink, Cadmium, Quecksilber oder Phosphor, X = Halogen, q = 2, 3 oder 4 und p = 1, 2, 3 oder 4. Zudem betrifft die Erfindung Verbindungen, erhältlich nach einem solchen Verfahren, deren Verwendung und ein Substrat, welches auf einer Oberfläche eine Aluminium-Schicht oder eine Aluminium enthaltende Schicht aufweist.

## Beschreibung

Die Erfindung betrifft Lithiumalkylaluminate gemäß der allgemeinen Formel Li[AlR₄]. Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren.

R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. Gegenstand der Erfindung sind weiterhin die Verwendung eines Lithiumalkylaluminats gemäß der allgemeinen Formel Li[AlR₄] als Transferreagenz zur Übertragung wenigstens eines Restes R sowie ein Verfahren zur Übertragung wenigstens eines Restes R auf eine Verbindung gemäß der allgemeinen Formel E(X)_{q} zur Herstellung einer Verbindung gemäß der allgemeinen Formel E(X)_{q-p}Rₚ. Dabei ist R wie oben definiert, E ist ausgewählt aus der Gruppe bestehend aus Aluminium, Gallium, Indium, Thallium, Germanium, Zinn, Blei, Antimon, Bismut, Zink, Cadmium, Quecksilber und Phosphor, X = Halogen, q = 2, 3 oder 4 und p = 1, 2, 3 oder 4. Zudem betrifft die Erfindung Verbindungen, erhältlich nach einem solchen Verfahren, deren Verwendung und ein Substrat, welches auf einer Oberfläche eine Aluminium-Schicht oder eine Aluminium enthaltende Schicht aufweist. Gegenstand der Erfindung ist außerdem ein Verfahren zur Herstellung von Lithiumalkylaluminaten gemäß der allgemeinen Formel Li[AlR₄], Verbindungen, erhältlich nach dem beanspruchten Verfahren, sowie deren Verwendung.

Metathetische Übertragungen von Alkylgruppen auf Element- und Metallhalogenide spielen eine wichtige Rolle in einer Vielzahl von Synthesesequenzen. Sie werden auch im industriellen Maßstab durchgeführt.

Üblicherweise kommen dabei Lithiumorganyle LiR oder Grignard-Reagenzien RMgX als Transferreagenzien zum Einsatz.

Bei Verwendung von Lithiumorganylen stellt die Bildung von LiX als Nebenprodukt die Triebkraft der Reaktion dar. Zudem sind Lithiumorganyle gut in aliphatischen, unpolaren Solventien löslich. Aufgrund ihrer Reaktionsfreudigkeit sind sie jedoch nicht universell für alle Reaktionssysteme anwendbar. Nachteilig an Lithiumorganylen sind insbesondere ihr hohes Reduktionsvermögen, welches sie aufgrund ihres hohen elektropositiven Charakters und ihrer Nukleophilie besitzen, die starke Exothermie der Reaktionen, an denen sie beteiligt sind, und der damit verbundene Selektivitätsverlust. Hinzu kommt, dass die quantitative Abtrennung der als Nebenprodukt anfallenden Salzfracht, insbesondere aus den üblicherweise eingesetzten polaren Lösungsmitteln, eine kaum zu bewältigende Herausforderung darstellt. Dies gilt insbesondere hinsichtlich ihrer Verwendung im industriellen Maßstab.

Grignard-Reagenzien sind vergleichsweise kostengünstig zugänglich. Synthesen, bei denen sie verwendet werden, zeigen in der Regel eine gute Reproduzierbarkeit. Allerdings ist bei ihrer Verwendung der Einsatz etherischer Lösungsmittel zwingend erforderlich. Das kann bei der späteren Anwendung der jeweiligen Zielverbindung zu Problemen führen. Werden Grignard-Reagenzien nämlich beispielsweise im Rahmen der Darstellung von Präkursoren für ein Gasphasenabscheidungsverfahren oder ein Gasphasenepitaxieverfahren eingesetzt, besteht die Gefahr, dass die hergestellten Präkursorverbindungen Verunreinigungen in Form von Sauerstoffspuren aufweisen. Infolgedessen kann es zur Abscheidung verunreinigter Metallschichten oder Metall enthaltender Schichten kommen, die für eine weitere Anwendung unbrauchbar sind.

Zudem kommen Aluminium-, Zink- und Siliziumalkyle, wie z. B. AlR₃, ZnR₂ und SiR₄, zum Einsatz. Der Nachteil dieser Alkylierungsmittel besteht darin, dass sie üblicherweise ausgehend von RLi oder RMgX synthetisiert werden.

Insgesamt sind die literaturbekannten Alkylierungsreagenzien als unbefriedigend einzustufen; einerseits aufgrund ihrer vergleichsweise geringen Selektivität und der schwierig abzutrennenden LiX-Fracht, andererseits wegen des unumgänglichen Einsatzes eines etherischen Lösungsmittels und der damit unter Umständen verbundenen Folgeprobleme.

Der Erfindung liegt daher die Aufgabe zugrunde, diese und weitere Nachteile des Standes der Technik zu überwinden und Verbindungen zur Verfügung zu stellen, welche sich für die Verwendung als Transferreagenzien zur Übertragung wenigstens eines Alkylrestes eignen. Dabei sollen sich die zu verwendenden Verbindungen dadurch auszeichnen, dass sie eine selektive Übertragung einer oder mehrerer Alkylreste ermöglichen, bei welcher ausschließlich vergleichsweise einfach abzutrennende Nebenprodukte anfallen. Des Weiteren soll ein einfaches und kostengünstiges Verfahren zur Übertragung wenigstens eines Alkylrestes zur Verfügung gestellt werden sowie Verbindungen, welche mittels eines solchen Verfahrens relativ einfach, kostengünstig, selektiv und in hoher Reinheit erhältlich sind. Zudem soll ein Substrat bereitgestellt werden, welches auf einer Oberfläche eine Aluminium-Schicht oder eine Aluminium enthaltende Schicht aufweist, welche unter Verwendung einer nach dem beanspruchten Verfahren - zur Übertragung wenigstens eines Alkylrestes - erhältlichen oder erhaltenen Verbindung herstellbar ist. Weiterhin soll ein Verfahren zur Herstellung der zu verwendenden Verbindungen zur Verfügung gestellt werden, mit welchem diese einfach, kostengünstig und reproduzierbar in guter Ausbeute und hoher Reinheit darstellbar sind. Dabei soll insbesondere auf etherische Lösungsmittel verzichtet werden.

Hauptmerkmale der Erfindung sind in Anspruch 1, Anspruch 3, Anspruch 4, Anspruch 14, einem der Ansprüche 16 bis 18, einem der Ansprüche 28 bis 32 oder in Anspruch 35 angegeben. Ausgestaltungen sind Gegenstand des Anspruchs 2, der Ansprüche 5 bis 13, der Ansprüche 19 bis 27, oder einem der Ansprüche 33 und 34.

Gelöst wird die Aufgabe durch Lithiumalkylaluminate gemäß der allgemeinen Formel Li[AlR₄] (I). Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. Dabei ist R^{A} ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren.

Ausgenommen sind Li[AltBu₄] und Li[Al(CH₂SiMe₃)₄]. Diese Verbindungen werden daher also nicht als solche beansprucht, sondern Gegenstand der Erfindung ist lediglich deren Verwendung als Transferreagenz zur Übertragung wenigstens eines Restes R.

Die beanspruchten, als Feststoffe oder Flüssigkeiten vorliegenden Lithiumalkylaluminate des Typs Li[AlR₄] (I) sind, insbesondere ausgehend von den kommerziell erhältlichen Verbindungen LiAlH₄ und RLi, selektiv, einfach, kostengünstig und reproduzierbar in guten Ausbeuten und Reinheiten darstellbar. Mithin sind sie auch im industriellen Maßstab herstellbar. Besonders vorteilhaft ist eine Verwendung von Li[AlR₄] (I) als Transferreagenz zur Übertragung wenigstens eines der vier Reste R auf ein Element- oder Metallhalogenid. Denn mit Li[AlR₄] (I) als Transferreagenz sind vorteilhafterweise selektiv ein, zwei, drei oder vier Reste R übertragbar. Mithin ist unter Verwendung von Li[AlR₄] (I) auch die Darstellung heteroleptischer Komplexe möglich. Im Zusammenhang mit der vorliegenden Erfindung wird von der Synthese eines heteroleptischen Komplexes gesprochen, wenn lediglich ein Teil der Halogenidanionen des eingesetzten Element- oder Metallhalogenids durch jeweils einen Rest R ersetzt wird. Alternativ kann ein Teil der Halogenidanionen bereits vor der Umsetzung mit Li[AlR₄] (I) durch andere, von R verschiedene Liganden ausgetauscht worden sein.

Weiterhin vorteilhaft ist, dass im Falle der Übertragung von vier Resten R ausgehend von einem Moläquivalent Li[AlR₄] (I) die anfallende Salzfracht - im Vergleich zum Einsatz eines Alkylierungsreagenzes, durch welches pro Moläquivalent lediglich ein Rest R übertragbar ist - deutlich verringert ist. In der Regel fällt ausschließlich LiAlX₄ als vergleichsweise einfach quantitativ abtrennbares Nebenprodukt an. Zudem sind Verbindungen gemäß der allgemeinen Formel Li[AlR₄] (I) in diversen nicht-etherischen organischen Lösungsmitteln herstellbar und zeigen eine gute Löslichkeit in ihnen, insbesondere in unpolaren Lösungsmitteln, wie z. B. den verschiedenen Isomeren von Pentan, Hexan und Decan. Dadurch wird - mit Blick auf eine weitere Umsetzung von Li[AlR₄] (I) - von vorneherein ausgeschlossen, dass das jeweilige Folgeprodukt, insbesondere ein Alkylierungsprodukt oder dessen Folgeprodukte, gegebenenfalls mit Ether beziehungsweise Sauerstoffspuren verunreinigt werden. Insbesondere hinsichtlich einer industriellen Anwendung ist bei der Verwendung von Li[AlR₄] (I) als Transferreagenz die - im Vergleich zu Umsetzungen mit gängigen Alkylierungsreagenzien - geringere Wärmetönung vorteilhaft. Dadurch werden nicht nur Energiekosten für die Kühlung eingespart, sondern es wird auch eine unter Sicherheitsaspekten günstigere Verfahrensführung ermöglicht.

Verbindungen gemäß der allgemeinen Formel Li[AlR₄] (I) können unmittelbar nach ihrer Isolierung weiter umgesetzt und/oder gelagert werden. Alternativ oder ergänzend kann die jeweilige Verbindung Li[AlR₄] (I) zur Herstellung einer definierten Stammlösung in einem unpolaren Lösungsmittel verwendet werden.

Die beanspruchten Lithiumalkylaluminate gemäß der allgemeinen Formel Li[AlR₄] (I) sind aus (atom)ökonomischer und ökologischer Sicht als befriedigend zu bewerten.

Gelöst wird die Aufgabe außerdem durch die Verwendung eines Lithiumalkylaluminats gemäß der allgemeinen Formel Li[AlR₄] (I) als Transferreagenz zur Übertragung wenigstens eines Restes R, insbesondere auf eine Verbindung gemäß der allgemeinen Formel E(X)_{q}. Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. E ist ausgewählt aus der Gruppe bestehend aus Aluminium, Gallium, Indium, Thallium, Germanium, Zinn, Blei, Antimon, Bismut, Zink, Cadmium, Quecksilber und Phosphor. Zudem gilt, dass X = Halogen und q = 2, 3 oder 4. Bevorzugt ist X = F, Cl oder Br, insbesondere Cl.

Bei der Verwendung eines Lithiumalkylaluminats gemäß der allgemeinen Formel Li[AlR₄] (I) als Transferreagenz handelt es sich um ein Verfahren zur Übertragung wenigstens eines Restes R auf eine Verbindung gemäß der allgemeinen Formel E(X)_{q} zur Herstellung einer Verbindung gemäß der allgemeinen Formel E(X)_{q-p}Rₚ (II) unter Verwendung eines Lithiumalkylaluminats gemäß der allgemeinen Formel Li[AlR₄] (I). Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. E ist ausgewählt aus der Gruppe bestehend aus Aluminium, Gallium, Indium, Thallium, Germanium, Zinn, Blei, Antimon, Bismut, Zink, Cadmium, Quecksilber und Phosphor. Zudem gilt, dass X = Halogen, q = 2, 3 oder 4 und p = 1, 2, 3 oder 4. Das Verfahren umfasst die Schritte:
a) Zurverfügungstellung des Lithiumalkylaluminats gemäß der allgemeinen Formel Li[AlR₄] (I),
   und
b) Umsetzung von E(X)_{q} mit dem Lithiumalkylaluminat Li[AlR₄] (I) in wenigstens einem aprotischen Lösungsmittel in einem Reaktionsgefäß.

Das aprotische Lösungsmittel kann auch ein Lösungsmittelgemisch sein. Mithin kann das aprotische Lösungsmittel beispielsweise zwei oder mehr aprotische Lösungsmittel umfassen.

Der Begriff Reaktionsgefäß ist nicht auf ein Volumen, eine Materialbeschaffenheit, eine Ausstattung oder eine Form beschränkt.

Die Variable q ist abhängig von der Oxidationszahl des jeweiligen Elements E. Beispielsweise ist q = 2 im Falle von Zink, q = 3 im Falle von Aluminium und q = 4 im Falle von Zinn.

Durch Verwendung von Li[AlR₄] (I) als Transferreagenz sind mit dem beanspruchten Verfahren vorteilhafterweise selektiv ein, zwei, drei oder vier Reste R übertragbar. Mithin ist mit dem oben beschriebenen Verfahren unter Verwendung von Li[AlR₄] (I) auch die Darstellung heteroleptischer Komplexe möglich. Im Zusammenhang mit der vorliegenden Erfindung wird von der Synthese eines heteroleptischen Komplexes gesprochen, wenn lediglich ein Teil der Halogenidanionen des eingesetzten Element- oder Metallhalogenids E(X)_{q} durch jeweils einen Rest R ersetzt wird. Alternativ kann ein Teil der Halogenidanionen bereits vor der Umsetzung mit Li[AlR₄] (I) durch andere, von R verschiedene Liganden ausgetauscht worden sein. Mithin ist das beanspruchte Verfahren zusätzlich zur selektiven Herstellung von Verbindungen des Typs E(X)_{q-p}Rₚ (II) auch für die selektive Darstellung einer Vielzahl von Verbindungen anwendbar, bei welchen ein Teil der Halogenidanionen durch andere Liganden als R ersetzt ist.

Besonders vorteilhaft bei der Verwendung von Li[AlR₄] (I) als Transferreagenz ist, dass insbesondere im Falle der Übertragung von vier Resten R ausgehend von einem Moläquivalent Transferreagenz die anfallende Salzfracht - im Vergleich zum Einsatz eines Alkylierungsreagenzes, durch welches pro Moläquivalent lediglich ein Rest R übertragbar ist - deutlich verringert wird. Denn in der Regel fällt ausschließlich LiAlX₄ als vergleichsweise einfach quantitativ abtrennbares Nebenprodukt an. Die Abtrennung kann z. B. mittels eines Filtrationsschrittes und/oder einer destillativen Abtrennung oder Kondensation einer flüchtigen Zielverbindung und/oder eines Lösungsmittels oder Lösungsmittelgemisches erfolgen. An die Kondensation schließt sich gegebenenfalls eine destillative Aufreinigung an. In Einzelfällen besteht die Salzfracht stattdessen aus LiX. Durch die Wahl des aprotischen Lösungsmittels ist die Abtrennung von LiX jedoch auch vergleichsweise einfach quantitativ möglich. Dazu kann ebenfalls ein Filtrationsschritt und/oder eine Abtrennung einer flüchtigen Zielverbindung und/oder eines Lösungsmittels oder Lösungsmittelgemisches mittels Destillation oder Kondensation vorgesehen sein. An letztere kann sich gegebenenfalls eine destillative Aufreinigung anschließen. Somit ist die Aufreinigung des jeweiligen Alkylierungsproduktes in der Regel besonders einfach und kostengünstig realisierbar. Dies ist mit Blick auf dessen Herstellung im industriellen Maßstab und dessen weitere Verwendung vorteilhaft. Ein weiterer Vorteil besteht darin, dass bei Verwendung von Li[AlR₄] (I) als Transferreagenz vollständig auf etherische Lösungsmittel verzichtet werden kann. Denn Li[AlR₄] (I) ist in diversen nicht-etherischen organischen Lösungsmitteln herstellbar und zeigt eine gute Löslichkeit in ihnen, insbesondere in unpolaren Lösungsmitteln, wie z. B. den verschiedenen Isomeren von Pentan, Hexan und Decan. Dadurch wird von vorneherein ausgeschlossen, dass das jeweilige Alkylierungsprodukt oder dessen Folgeprodukte gegebenenfalls mit Ether beziehungsweise Sauerstoffspuren verunreinigt werden. Insbesondere mit Blick auf eine industrielle Anwendung ist die - im Vergleich zu Umsetzungen mit gängigen Alkylierungsreagenzien - geringere Wärmetönung vorteilhaft. Dadurch werden nicht nur Energiekosten für die Kühlung eingespart, sondern es wird auch eine unter Sicherheitsaspekten günstigere Verfahrensführung ermöglicht.

Die unter Verwendung von Li[AlR₄] (I) mit dem beanspruchten Verfahren darstellbaren Verbindungen gemäß der allgemeinen Formel E(X)_{q-p}Rₚ (II) werden in guten bis sehr guten Ausbeuten, von z. T. > 80%, und in hoher Reinheit erhalten, wie weiter oben ausgeführt.

Das beanspruchte Verfahren sieht im einfachsten Fall, nämlich einer *in situ*-Erzeugung des jeweiligen alkylierten Produktes für eine sich direkt anschließende weitere Umsetzung, vorteilhafterweise lediglich einen Umsetzungsschritt vor. Mithin ist das gewünschte Endprodukt vorteilhafterweise gegebenenfalls mittels einer Eintopfsynthese darstellbar.

Insgesamt werden durch die beanspruchte Verwendung eines Lithiumalkylaluminats gemäß der allgemeinen Formel Li[AlR₄] (I) als Transferreagenz beziehungsweise das beanspruchte Verfahren zur Übertragung wenigstens eines Restes R auf eine Verbindung gemäß der allgemeinen Formel E(X)_{q} zur Herstellung einer Verbindung gemäß der allgemeinen Formel E(X)_{q-p}Rₚ (II) unter Verwendung einer Verbindung des Typs Li[AlR₄] (I) die Nachteile des Standes der Technik überwunden. Das beanspruchte Verfahren ist aus (atom)ökonomischer und ökologischer als befriedigend zu bewerten.

Eine Ausführungsform der beanspruchten Verwendung von Li[AlR₄] (I) beziehungsweise des beanspruchten Verfahrens sieht vor, R ausgewählt ist aus der Gruppe bestehend aus Me, Et, *n*Pr, *i*Pr, *n*Bu, *t*Bu, *s*Bu, *i*Bu, CH(Me)(*i*Pr), CH(Me)(*n*Pr), CH(Et)₂, CH(Et)(Me)₂, CH₂C₆H₅, C₆H₅, CH₂SiMe₃, CH₂SiEt₃, CH₂Si(Me)₂(OMe), CH₂Si(Et)₂(OEt), CH₂Si(Me)(*t*Bu)(OMe), CH₂Si(*t*Bu)(C₆H₅)(O*t*Bu) und CH₂Si(*i*Pr)₂(O*i*Pr). Die Verwendung dieser Verbindungen, z. B. von Li[Al*t*Bu₄] und Li[Al(CH₂SiMe₃)₄], ist aufgrund der durch sie selektiv übertragbaren Alkylreste R präparativ, auch im industriellen Maßstab, von Interesse.

In einer weiteren Ausführungsform der beanspruchten Verwendung von Li[AlR₄] (I) beziehungsweise des beanspruchten Verfahrens ist für das zu alkylierende Edukt, d. h. das Element- oder Metallhalogenid Formel E(X)_{q}, vorgesehen, dass X = F, Cl oder Br ist.

Eine andere Variante der beanspruchten Verwendung von Li[AlR₄] (I) beziehungsweise des beanspruchten Verfahrens sieht vor, dass die Umsetzung von E(X)_{q} mit dem Lithiumalkylaluminat Li[AlR₄] (I) folgende Schritte umfasst:
i) Bereitstellen einer Lösung oder einer Suspension von E(X)_{q} in einem ersten Lösungsmittel,
ii) Hinzufügen des Lithiumalkylaluminats Li[AlR₄] (I), wobei während des Hinzufügens und/oder nach dem Hinzufügen von Li[AlR₄] (I) eine Reaktion von E(X)_{q} mit Li[AlR₄] (I) erfolgt.

Dabei kann das erste Lösungsmittel auch ein Lösungsmittelgemisch sein.

In einer Ausführungsform der beanspruchten Verwendung von Li[AlR₄] (I) beziehungsweise des beanspruchten Verfahrens ist ein molares Verhältnis E(X)_{q} : Li[AlR₄] (I) ≥ 1 : 3. Mithin beträgt das molare Verhältnis E(X)_{q} : Li[AlR₄] (I) wenigstens 1/3, also ein Drittel.

Das molare Verhältnis E(X)_{q} : Li[AlR₄] (I) wird zum einen in Abhängigkeit von der Anzahl der zu übertragenden Reste R gewählt, zum anderen unter Berücksichtigung des jeweils als Edukt eingesetzten Element- oder Metallhalogenids E(X)_{q}. Bei Vorliegen eines Moläquivalents des Lithiumalkylaluminats Li[AlR₄] (I) sind grundsätzlich alle vier Reste R selektiv übertragbar. Je nach Verfahrensführung und eingesetzter Stöchiometrie der Edukte E(X)_{q} und Li[AlR₄] (I) sind vorteilhafterweise selektiv ein, zwei, drei oder vier Reste R übertragbar. Erfolgt beispielsweise die Umsetzung von PCl₃ mit Li[Al*t*Bu₄] und beträgt das molare Verhältnis dieser beiden Edukte 4 : 1, also vier, so werden vier Mol PCl₂*t*Bu erhalten. Es findet also eine Einfachalkylierung statt. Anders verhält es sich, wenn ZnCl₂ mit Li[Al*t*Bu₄] umgesetzt wird und das molare Verhältnis der Edukte 1 : 0,5, also zwei, beträgt. In diesem Fall erfolgt eine Zweifachalkylierung, sodass ein Mol Zn*t*Bu₂ erhalten wird. Ein noch anderes Beispiel stellt die Umsetzung von AlCl₃ mit Li[Al*t*Bu₄] im molaren Verhältnis 1 : 3, also ein Drittel, dar. Auf diese Weise werden vier Mol Al*t*Bu₃ synthetisiert, wobei drei Mol LiCI ausfallen.

In einer Variante der beanspruchten Verwendung von Li[AlR₄] (I) beziehungsweise des beanspruchten Verfahrens ist vorgesehen, dass in Schritt ii) Li[AlR₄] (I) in einem zweiten Lösungsmittel suspendiert oder gelöst hinzugefügt wird. Dies kann - in Abhängigkeit von den übrigen Reaktionsparametern - zur besseren Kontrolle des Reaktionsverlaufs bzw. der Exothermie vorteilhaft sein. Das Hinzufügen des Lithiumalkylaluminats Li[AlR₄] (I) als Lösung oder Suspension in dem zweiten Lösungsmittel erfolgt beispielsweise unter Verwendung einer Dosiervorrichtung, insbesondere durch Zutropfen oder Zuspritzen. Alternativ oder ergänzend kann in einer Zuleitung des Reaktionsbehältnisses ein Absperrventil und/oder ein Absperrhahn vorgesehen sein.

Eine weitere Ausführungsform sieht vor, dass das zweite Lösungsmittel mit dem ersten Lösungsmittel mischbar oder identisch ist. Im Zusammenhang mit der vorliegenden Erfindung werden zwei Lösungsmittel als mischbar bezeichnet, wenn sie wenigstens während der jeweiligen Umsetzung mischbar sind, also nicht als zwei Phasen vorliegen.

In einer noch anderen Ausführungsform der beanspruchten Verwendung von Li[AlR₄] (I) beziehungsweise des beanspruchten Verfahrens wird E(X)_{q} als Feststoff bereitgestellt beziehungsweise vorgelegt. Dann erfolgt das Hinzufügen von Li[AlR₄] (I) als Lösung oder Suspension in dem zweiten Lösungsmittel, beispielsweise durch Zutropfen oder Zuspritzen.

In einer alternativen Ausführungsform der beanspruchten Verwendung von Li[AlR₄] (I) beziehungsweise des beanspruchten Verfahrens wird in Schritt ii) Li[AlR₄] (I) als Feststoff hinzugefügt, beispielsweise über einen Trichter oder eine trichterähnliche Vorrichtung.

Eine weitere Variante der beanspruchten Verwendung von Li[AlR₄] (I) beziehungsweise des beanspruchten Verfahrens sieht für die Umsetzung von E(X)_{q} mit dem Lithiumalkylaluminat Li[AlR₄] (I) vor, dass in einem ersten Schritt eine Lösung oder Suspension des Lithiumalkylaluminats Li[AlR₄] (I) in einem ersten Lösungsmittel bereitgestellt beziehungsweise vorgelegt wird. In einem zweiten Schritt erfolgt das Hinzufügen von E(X)_{q} als Feststoff oder als Suspension oder Lösung in einem zweiten Lösungsmittel. Dabei sind das erste Lösungsmittel und das zweite Lösungsmittel mischbar; sie können aber auch identisch sein.

Je nach Wahl des Lösungsmittels oder Lösungsmittelgemisches sowie der übrigen Reaktionsbedingungen, wie z. B. Zugabeform von Li[AlR₄] (I), d. h. als Substanz bzw. Feststoff oder gelöst in dem zweiten Lösungsmittel, Geschwindigkeit des Hinzufügens von Li[AlR₄] (I), Rührgeschwindigkeit, Innentemperatur des Reaktionsgefäßes, erfolgt die Reaktion von E(X)_{q} mit Li[AlR₄] (I) bereits während des Hinzufügens und/oder nach dem Hinzufügen von Li[AlR₄] (I).

In einer anderen Ausführungsform der beanspruchten Verwendung von Li[AlR₄] (I) beziehungsweise des beanspruchten Verfahrens sind das erste Lösungsmittel und das zweite Lösungsmittel unabhängig voneinander ausgewählt aus der Gruppe bestehend aus Kohlenwasserstoffen, Benzol und Benzolderivaten. Beispielsweise sind das erste Lösungsmittel und das zweite Lösungsmittel unabhängig voneinander ausgewählt aus der Gruppe bestehend aus *n*-Pentan, *n*-Hexan, *n*-Heptan, *n*-Octan, *n*-Nonan, *n*-Decan, *n*-Undecan, *n*-Dodecan, Cyclopentan, Cyclohexan, Cycloheptan, 1-Penten, 1-Hexen, 1-Hepten, 1-Octen, 1-Nonen, 1-Decen, 1-Undecen, 1-Dodecen, Cyclohexen, Benzol, Toluol und Xylol sowie deren Isomeren. Auch der Einsatz von Gemischen zweier oder mehrerer Lösungsmittel ist jeweils möglich, insbesondere von Gemischen aliphatischer Kohlenwasserstoffe. Bevorzugt sind *n*-Pentan, *n*-Hexan, *i*-Hexan und *n*-Decan sowie mögliche Gemische. Die Verwendung eines vergleichsweise hochsiedenden Lösungsmittels, z. B. von n-Decan, oder eines relativ hochsiedenden Lösungsmittelgemisches ist besonders vorteilhaft, wenn die jeweilige Zielverbindung des Typs E(X)_{q-p}Rₚ (II) destillativ abtrennbar ist. Denn dadurch ist die Abtrennung der bei der Umsetzung von Li[AlR₄] (I) mit E(X)_{q} angefallenen Salzfracht besonders einfach quantitativ möglich, weil sie im Reaktionsgefäß verbleibt. Zudem ist das Edukt Li[AlR₄] (I) in Lösungsmitteln wie n-Decan gut löslich.

In einer weiteren Ausführungsform der beanspruchten Verwendung von Li[AlR₄] (I) beziehungsweise des beanspruchten Verfahrens wird die Umsetzung von E(X)_{q} mit dem Lithiumalkylaluminat Li[AlR₄] (I) bei einer Innentemperatur T_{W} des Reaktionsgefäßes durchgeführt. Dabei beträgt die Innentemperatur T_{W} zwischen -50 °C und 100 °C. Aufgrund der Exothermie der Reaktion kann es von Vorteil sein, die Geschwindigkeit des Hinzufügens von Li[AlR₄] (I) und/oder die Innentemperatur T_{W} des Reaktionsgefäßes vergleichsweise niedrig zu wählen. Alternativ oder ergänzend kann vorgesehen sein, dass eine Lösung oder Suspension von Li[AlR₄] (I) in dem zweiten Lösungsmittel oder Lösungsmittelgemisch hinzugefügt wird. Die jeweilige Vorgehensweise ist unter Berücksichtigung der übrigen Reaktionsparameter, wie z. B. der E(X)_{q}-Konzentration und des Lösungsmittels oder Lösungsmittelgemisches, zu wählen.

Eine Innentemperatur des Reaktionsgefäßes kann mithilfe eines Temperatursensors oder mehrerer Temperatursensoren für einen Bereich oder mehrere Bereiche des Reaktionsgefäßes ermittelt werden. Dabei ist zumindest ein Temperatursensor für die Ermittlung der Innentemperatur T_{W} vorgesehen, welche in der Regel einer Durchschnittstemperatur T_{D1} des Reaktionsgemisches entspricht.

In einer anderen Variante der beanspruchten Verwendung von Li[AlR₄] (I) beziehungsweise des beanspruchten Verfahrens beträgt die Innentemperatur T_{W} des Reaktionsgefäßes während der Umsetzung von E(X)_{q} mit Li[AlR₄] (I) zwischen -40 °C und 80 °C. In einer noch anderen Variante beträgt die Innentemperatur Tw des Reaktionsgefäßes während der Umsetzung von E(X)_{q} mit Li[AlR₄] (I) zwischen - 30 °C und 60 °C.

In einer weiteren Ausführungsform der beanspruchten Verwendung von Li[AlR₄] (I) beziehungsweise des beanspruchten Verfahrens wird die Innentemperatur T_{W} des Reaktionsgefäßes unter Verwendung eines Wärmeträgers Ww geregelt und/oder gesteuert wird. Dazu kann beispielsweise ein Kryostat verwendet werden, welcher einen Wärmeträger beinhaltet, der idealerweise sowohl als Kühlmittel als auch als Wärmemittel fungieren kann. Durch den Einsatz des Wärmeträgers W_{W} können Abweichungen der Innentemperatur T_{W} von einem für die Umsetzung von E(X)_{q} mit Li[AlR₄] (I) festgelegten Sollwert T_{S1} weitestgehend abgefangen bzw. kompensiert werden. Die Realisierung einer konstanten Innentemperatur T_{W} ist aufgrund der üblichen Geräteabweichungen kaum möglich. Durch die Verwendung des Wärmeträgers W_{W} kann die Umsetzung von E(X)_{q} mit Li[AlR₄] (I) aber zumindest in einem vorgewählten Temperaturbereich oder in mehreren vorgewählten Temperaturbereichen durchgeführt werden. So kann es beispielsweise - in Abhängigkeit von den übrigen Reaktionsparametern - zur noch besseren Kontrolle des Reaktionsverlaufs bzw. der Exothermie vorteilhaft sein, ein Temperaturprogramm zu erstellen. Dabei kann zum Beispiel während einer ersten Phase des Hinzufügens von Li[AlR₄] (I) eine niedrigere Temperatur bzw. ein niedrigerer Temperaturbereich gewählt werden als in einer zweiten Phase des Hinzufügens von Li[AlR₄] (I). Es können auch mehr als zwei Phasen des Hinzufügens und damit mehr als zwei vorgewählte Temperaturen bzw. Temperaturbereiche vorgesehen sein. Je nach Wahl der übrigen Reaktionsbedingungen, wie z. B. der E(X)_{q}-Konzentration und des Lösungsmittels oder Lösungsmittelgemisches, kann es während des Hinzufügens und/oder nach dem Hinzufügen von Li[AlR₄] (I) günstig sein, eine, gegebenenfalls auch schrittweise, Erniedrigung der Innentemperatur T_{W} des Reaktionsgefäßes unter Verwendung des Wärmeträgers W_{W} durchzuführen. Dadurch kann unter Umständen sichergestellt werden, dass die Umsetzung von E(X)_{q} mit Li[AlR₄] (I) langsamer und damit kontrollierter, insbesondere hinsichtlich der Wärmetönung, erfolgt. Im Anschluss an eine Erniedrigung der Innentemperatur T_{W} des Reaktionsgefäßes kann eine, auch schrittweise, Erhöhung der Innentemperatur T_{W} vorgesehen sein, damit die Umsetzung von E(X)_{q} mit Li[AlR₄] (I) vervollständigt wird.

Eine weitere Ausführungsform der beanspruchten Verwendung von Li[AlR₄] (I) beziehungsweise des beanspruchten Verfahrens sieht vor, dass eine Innentemperatur T_{K} des Reaktionsgefäßes während des Hinzufügens und/oder nach dem Hinzufügen von Li[AlR₄] (I) zwischen -60 °C und 50 °C beträgt. In einer weiteren Variante des Verfahrens beträgt die Innentemperatur T_{K} des Reaktionsgefäßes während des Hinzufügens und/oder nach dem Hinzufügen von Li[AlR₄] (I) zwischen -50 °C und 50 °C. In einer noch anderen Ausführungsform des Verfahrens beträgt die Innentemperatur T_{K} des Reaktionsbehältnisses während des Hinzufügens und/oder nach dem Hinzufügen von Li[AlR₄] (I) zwischen -40 °C und 50 °C. Dabei ist zumindest ein Temperatursensor für die Ermittlung der Innentemperatur T_{K} vorgesehen, welche in der Regel einer Durchschnittstemperatur T_{D2} des Reaktionsgemisches entspricht. Der Temperatursensor kann identisch mit demjenigen für die Ermittlung der Innentemperatur T_{W} sein.

In einer weiteren Ausführungsform der beanspruchten Verwendung von Li[AlR₄] (I) beziehungsweise des beanspruchten Verfahrens wird die Innentemperatur T_{K} des Reaktionsgefäßes unter Verwendung eines Wärmeträgers W_{K} geregelt und/oder gesteuert. Dazu kann beispielsweise ein Kryostat verwendet werden, welcher einen Wärmeträger beinhaltet, der idealerweise sowohl als Kühlmittel als auch als Wärmemittel fungieren kann. Durch den Einsatz des Wärmeträgers W_{K} können Abweichungen der Innentemperatur T_{K} von einem für die Zeit während des Hinzufügens und/oder nach dem Hinzufügen von Li[AlR₄] (I) festgelegten Sollwert T_{S2} weitestgehend abgefangen bzw. kompensiert werden. Die Realisierung einer konstanten Innentemperatur Tc ist aufgrund der üblichen Geräteabweichungen kaum möglich. Durch die Verwendung des Wärmeträgers W_{K} kann die Umsetzung von E(X)_{q} mit Li[AlR₄] (I) aber zumindest in einem vorgewählten Temperaturbereich oder in mehreren vorgewählten Temperaturbereichen durchgeführt werden. So kann es beispielsweise - in Abhängigkeit von den übrigen Reaktionsparametern - zur noch besseren Kontrolle des Reaktionsverlaufs bzw. der Exothermie vorteilhaft sein, ein Temperaturprogramm zu erstellen. Dabei kann zum Beispiel während einer ersten Phase des Hinzufügens von Li[AlR₄] (I) eine niedrigere Temperatur bzw. ein niedrigerer Temperaturbereich gewählt werden als in einer zweiten Phase des Hinzufügens von Li[AlR₄] (I). Es können auch mehr als zwei Phasen des Hinzufügens und damit mehr als zwei vorgewählte Temperaturen bzw. Temperaturbereiche vorgesehen sein.

In einer anderen Ausführungsform der beanspruchten Verwendung von Li[AlR₄] (I) beziehungsweise des beanspruchten Verfahrens wird nach dem Schritt, umfassend die Umsetzung von E(X)_{q} mit Li[AlR₄] (I), ein weiterer Schritt durchgeführt. Der weitere Schritt umfasst eine Isolierung von E(X)_{q-p}Rₚ (II). Soll die jeweils in Lösung befindliche Verbindung E(X)_{q-p}Rₚ (II) nicht unmittelbar einer weiteren Reaktion unterworfen werden, sondern isoliert und dann gelagert und/oder weiterverwendet werden, kann ihre Isolierung einen oder mehrere Schritte umfassen. In einer Variante des Verfahrens umfasst die Isolierung einen Filtrationsschritt. Dabei können auch mehrere Filtrationsschritte vorgesehen sein, gegebenenfalls auch eine oder mehrere Filtrationen über einem Reinigungsmedium, wie z. B. Aktivkohle oder Silica, z. B. Celite®. Der Filterkuchen, welcher die LiAlX₄-Fracht oder LiX umfasst, kann mit einer geringen Menge eines relativ leicht flüchtigen Lösungsmittels, wie z. B. n-Pentan, n-Hexan oder *i*-Hexan, gewaschen werden, um eventuell in der LiAlX₄- oder LiX-Fracht enthaltenes Produkt zu extrahieren. Die Isolierung kann weitere Verfahrensschritte umfassen, wie z. B. die Reduzierung des Volumens der Mutterlauge, d. h. Einengen, z. B. mittels "bulb-to-bulb", die Zugabe eines Lösungsmittels und/oder einen Lösungsmittelaustausch, um eine Fällung des Produktes aus der Mutterlauge zu erzielen und/oder Verunreinigungen und/oder Edukte zu entfernen, Waschen und Trocknen, auch Gefriertrocknen, des Produktes, eine Kondensation, eine Destillation und/oder eine Sublimation.

Die Aufgabe wird weiterhin gelöst durch Verbindungen gemäß der allgemeinen Formel E(X)_{q-p}Rₚ (II), erhältlich nach einem Verfahren zur Übertragung wenigstens eines Restes R auf eine Verbindung gemäß der allgemeinen Formel E(X)_{q}, unter Verwendung eines Lithiumalkylaluminats gemäß der allgemeinen Formel Li[AlR₄] (I), gemäß einem der weiter oben beschriebenen Ausführungsbeispiele.

Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. E ist ausgewählt aus der Gruppe bestehend aus Aluminium, Gallium, Indium, Thallium, Germanium, Zinn, Blei, Antimon, Bismut, Zink, Cadmium, Quecksilber und Phosphor. Zudem gilt, dass X = Halogen, insbesondere X = F, Cl oder Br, q = 2, 3 oder 4 und p = 1, 2, 3 oder 4.

Besonders vorteilhaft ist, dass die nach dem weiter oben beschriebenen Verfahren erhältlichen Verbindungen des E(X)_{q-p}Rₚ (II) vergleichsweise rein erhalten werden, ohne dass eine aufwändige Aufreinigung erforderlich ist. Denn die üblicherweise bei der Darstellung als einziges Nebenprodukt anfallende LiAlX₄-Fracht lässt sich vergleichsweise einfach quantitativ abtrennen. Die Abtrennung kann z. B. mittels eines Filtrationsschrittes und/oder einer destillativen Abtrennung oder Kondensation einer flüchtigen Zielverbindung und/oder eines Lösungsmittels oder Lösungsmittelgemisches erfolgen. An die Kondensation schließt sich gegebenenfalls eine destillative Aufreinigung an. In Einzelfällen besteht die Salzfracht stattdessen aus LiX. Durch die Wahl des aprotischen Lösungsmittels ist die Abtrennung von LiX jedoch auch vergleichsweise einfach quantitativ möglich. Dazu kann ebenfalls ein Filtrationsschritt und/oder eine Abtrennung einer flüchtigen Zielverbindung und/oder eines Lösungsmittels oder Lösungsmittelgemisches mittels Destillation oder Kondensation vorgesehen sein. An letztere kann sich gegebenenfalls eine destillative Aufreinigung anschließen. Somit ist die Aufreinigung der jeweils erhaltenen Verbindung des Typs E(X)_{q-p}Rₚ (II) in der Regel besonders einfach und kostengünstig realisierbar. Dies ist mit Blick auf dessen Herstellung im industriellen Maßstab und dessen weitere Verwendung vorteilhaft. Ein weiterer Vorteil besteht darin, dass bei Verwendung von Li[AlR₄] (I) als Transferreagenz vollständig auf etherische Lösungsmittel verzichtet werden kann. Denn Li[AlR₄] (I) ist in diversen nicht-etherischen organischen Lösungsmitteln herstellbar und zeigt eine gute Löslichkeit in ihnen, insbesondere in unpolaren Lösungsmitteln, wie z. B. den verschiedenen Isomeren von Pentan, Hexan und Decan. Dadurch wird von vorneherein ausgeschlossen, dass das jeweilige Alkylierungsprodukt E(X)_{q-p}Rₚ (II) oder dessen Folgeprodukte gegebenenfalls mit Ether beziehungsweise Sauerstoffspuren verunreinigt werden.

Außerdem sind durch Verwendung eines Lithiumalkylaluminats gemäß der allgemeinen Formel Li[AlR₄] (I) als Transferreagenz mit dem weiter oben beschriebenen Verfahren vorteilhafterweise selektiv ein, zwei, drei oder vier Reste R auf eine Verbindung gemäß der allgemeinen Formel E(X)_{q} übertragbar. Mithin sind mit diesem Verfahren unter auch heteroleptische Komplexe des Typs E(X)_{q-p}Rₚ (II) erhältlich.

Besonders vorteilhaft bei der Verwendung von Li[AlR₄] (I) als Transferreagenz ist, dass insbesondere im Falle der Übertragung von vier Resten R ausgehend von einem Moläquivalent Transferreagenz die anfallende Salzfracht - im Vergleich zum Einsatz eines Alkylierungsreagenzes, durch welches pro Moläquivalent lediglich ein Rest R übertragbar ist - deutlich verringert wird. Insbesondere mit Blick auf eine industrielle Herstellung von Verbindungen des Typs E(X)_{q-p}Rₚ (II) nach einer Ausführungsform des weiter oben beschriebenen Verfahrens zur Übertragung wenigstens eines Restes R auf eine Verbindung gemäß der allgemeinen Formel E(X)_{q} ist die - im Vergleich zu Umsetzungen mit gängigen Alkylierungsreagenzien - geringere Wärmetönung vorteilhaft.

Insgesamt sind die mit dem weiter oben beschriebenen Verfahren erhältlichen Verbindungen des Typs E(X)_{q-p}Rₚ (II) unter ökonomischen und ökologischen Aspekten als zufriedenstellend einzustufen.

Zu den so erhältlichen Verbindungen zählen beispielsweise Al*t*Bu₃, Al(CH₂SiMe₃)₃, Ga*t*Bu₃, Ga(CH₂SiMe₃)₃, In*t*Bu₃, In(CH₂SiMe₃)₃, Tl*t*Bu₃, Tl(CH₂SiMe₃)₃, GeCl₂*t*Bu₂, GeCl₂(CH₂SiMe₃)₂, SnCl₃*t*Bu, SnCl₂*t*Bu₂, SnCl*t*Bu₃, Sn*t*Bu₄, Sn(CH₂SiMe₃)₄, PbCl₃*t*Bu, SbCl₂*t*Bu, SbCl*t*Bu₂, Sb*t*Bu₃, Bi*t*Bu₃, Zn*t*Bu₂, Cd*t*Bu₂, Hg*t*Bu₂, PCl₂*t*Bu, PCl*t*Bu₂ und P*t*Bu₃.

In einer Ausführungsform der Verbindungen gemäß der allgemeinen Formel E(X)_{q-p}Rₚ (II) liegen die Verbindungen isomerenrein vor. Isomerenrein bedeutet im Rahmen der vorliegenden Erfindung, dass das gewünschte Isomer mit einem Anteil von ≥ 90 %, bevorzugt von ≥ 95 %, besonders bevorzugt von ≥ 99 % vorliegt. Dabei ist die Isomerenreinheit beispielsweise mittels Kernresonanzspektroskopie bestimmt.

In einer weiteren Variante der Verbindungen gemäß der allgemeinen Formel E(X)_{q-p}Rₚ (II) liegt die Verbindung Al*t*Bu₃ isomerenrein vor. Es ist bekannt, dass Al*t*Bu₃ zur Isomerisierung zu Al(*i*Bu)ₓ(*t*Bu)₃₋ₓ neigt, wobei x = 1, 2 oder 3. Mittels des weiter oben beschriebenen Verfahrens ist Al*t*Bu₃ vorteilhafterweise besonders rein, nämlich sogar in Form farbloser Kristalle, und reproduzierbar erhältlich. Im Unterschied dazu wird die Verbindung Al*t*Bu₃, hergestellt nach einem literaturbekannten Verfahren, häufig als farblose Flüssigkeit beschrieben. Vorliegend wurden sogar für die Einkristallstrukturanalyse geeignete Kristalle erhalten. Weil es während der Messung zu einem Phasenübergang kam, reicht die Güte des Datensatzes lediglich als Strukturbeleg aus, nicht aber zur Diskussion von Strukturparametern. Die Struktur wurde jedoch bereits in der Literatur beschrieben. Bei dem mittels des weiter oben beschriebenen Verfahrens erhaltenen Produkt Al*t*Bu₃ wird die bekannte Isomerisierung zu Al*i*Bu*t*Bu₂ und Folgeprodukten nicht beobachtet. Auch nach mehreren Monaten liegt das Produkt isomerenrein im Sinne der oben genannten Definition vor. Zudem ist die Ausbeute mit > 80% zufriedenstellend, auch mit Blick auf eine industrielle Anwendung dieser Verbindung.

Verbindungen gemäß der allgemeinen Formel E(X)_{q-p}Rₚ (II) sind gemäß einem der weiter oben beschriebenen Ausführungsbeispiele des Verfahrens selektiv, einfach und kostengünstig erhältlich. Neben einer hohen Isomerenreinheit weisen sie eine vergleichsweise hohe Reinheit in Bezug auf anorganische Salze und Sauerstoff auf. Letzteres ist unter anderem darauf zurückzuführen, dass - im Unterschied zu literaturbekannten Synthesenvorschriften - sowohl bei der Darstellung der Edukte Li[AlR₄] (I) als auch im Rahmen der Herstellung von Verbindungen des Typs E(X)_{q-p}Rₚ (II) auf etherische Lösungsmittel verzichtet wird. Somit eignen sich die mit dem weiter oben beschriebenen Verfahren erhältlichen Verbindungen des Typs E(X)_{q-p}Rₚ (II) auch als Edukte für die Herstellung von Präkursorverbindungen, z. B. für ein Gasphasenepitaxieverfahren oder ein Gasphasenabscheidungsverfahren.

Außerdem wird die Aufgabe gelöst durch die Verwendung einer Verbindung E(X)₂R zur Herstellung einer Verbindung gemäß der allgemeinen Formel (R)EH₂ (III). Die zu verwendende Verbindung E(X)₂R ist erhalten oder erhältlich nach einem Verfahren zur Übertragung wenigstens eines Restes R auf eine Verbindung gemäß der allgemeinen Formel E(X)_{q}, wobei X = Halogen, insbesondere X = F, Cl oder Br, und q = 2, 3 oder 4, unter Verwendung eines Lithiumalkylaluminats gemäß der allgemeinen Formel Li[AlR₄] (I), gemäß einem der weiter oben beschriebenen Ausführungsbeispiele. Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. E ist ausgewählt aus der Gruppe bestehend aus Phosphor, Antimon und Bismuth.

Bei der vorgenannten Verwendung einer Verbindung E(X)₂R zur Herstellung einer Verbindung gemäß der allgemeinen Formel (R)EH₂ (III) handelt es sich um ein Verfahren zur Herstellung einer Verbindung gemäß der allgemeinen Formel (R)EH₂ (III) unter Verwendung einer Verbindung gemäß der allgemeinen E(X)₂R. Die zu verwendende Verbindung E(X)₂R ist erhalten oder erhältlich nach einem Verfahren zur Übertragung wenigstens eines Restes R auf eine Verbindung gemäß der allgemeinen Formel E(X)_{q}, wobei X = Halogen, insbesondere X = F, Cl oder Br, und q = 2, 3 oder 4, unter Verwendung eines Lithiumalkylaluminats gemäß der allgemeinen Formel Li[AlR₄] (I), gemäß einem der weiter oben beschriebenen Ausführungsbeispiele. Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. E ist ausgewählt aus der Gruppe bestehend aus Phosphor, Antimon und Bismuth.
Das Verfahren umfasst die Schritte:
a) Zurverfügungstellung der Verbindung E(X)₂R,
   und
b) Umsetzung von E(X)₂R mit einem hydridischen Reduktionsmittel in wenigstens einem aprotischen Lösungsmittel S_{X} in einem Reaktionsbehältnis.

Der Begriff Reaktionsbehältnis ist nicht auf ein Volumen, eine Materialbeschaffenheit, eine Ausstattung oder eine Form beschränkt.

Die bei dem beanspruchten Verfahren zu verwendenden Verbindungen E(X)₂R sind mittels des weiter oben beschriebenen Verfahrens selektiv, einfach und kostengünstig erhältlich. Sie weisen eine vergleichsweise hohe Reinheit in Bezug auf anorganische Salze und Sauerstoff auf. Letzteres ist unter anderem darauf zurückzuführen, dass - im Unterschied zu literaturbekannten Synthesevorschriften - sowohl bei der Darstellung der Edukte Li[AlR₄] (I) als auch im Rahmen der Herstellung von Verbindungen des Typs E(X)₂R auf etherische Lösungsmittel verzichtet wird. Somit eignen sich die mit dem weiter oben beschriebenen Verfahren erhältlichen Verbindungen des Typs E(X)₂R auch als Edukte für die Herstellung Verbindungen gemäß der allgemeinen Formel (R)EH₂ (III), welche eine vergleichsweise hohe Reinheit aufweisen. Mit dem hier beschriebenen Verfahren zur Herstellung einer Verbindung gemäß der allgemeinen Formel (R)EH₂ (III) ist beispielsweise *t*BuPH₂ (TBP) auf besonders einfache Weise selektiv und in hoher Reinheit erhältlich.

In einer Ausführungsform des beanspruchten Verfahrens wird in Schritt a) die Verbindung E(X)₂R als Lösung in einem aprotischen Lösungsmittel S_{R} oder als Feststoff in dem Reaktionsbehältnis zur Verfügung gestellt beziehungsweise vorgelegt. In Schritt b) erfolgt die Umsetzung von E(X)₂R mit dem hydridischen Reduktionsmittel, wobei die Umsetzung das Hinzufügen einer Lösung oder einer Suspension des hydridischen Reduktionsmittel in dem aprotischen Lösungsmittel Sx zu der als Lösung in dem aprotischen Lösungsmittel S_{R} oder als Feststoff vorgelegten Verbindung E(X)₂R umfasst. Das Hinzufügen der Lösung oder der Suspension des hydridischen Reduktionsmittels kann beispielsweise durch Zutropfen oder Zuspritzen erfolgen.

In einer weiteren Ausführungsform des beanspruchten Verfahrens sind das Lösungsmittel S_{R} und das Lösungsmittel S_{X} unabhängig voneinander ausgewählt aus der Gruppe bestehend aus Kohlenwasserstoffen, Benzol und Benzolderivaten. Beispielsweise sind das Lösungsmittel S_{R} und das Lösungsmittel S_{X} unabhängig voneinander ausgewählt aus der Gruppe bestehend aus *n*-Pentan, *n*-Hexan, *n*-Heptan, *n*-Octan, *n*-Nonan, *n*-Decan, *n*-Undecan, *n*-Dodecan, Cyclopentan, Cyclohexan, Cycloheptan, 1-Penten, 1-Hexen, 1-Hepten, 1-Octen, 1-Nonen, 1-Decen, 1-Undecen, 1-Dodecen, Cyclohexen, Benzol, Toluol und Xylol sowie deren Isomeren. Auch der Einsatz von Gemischen zweier oder mehrerer Lösungsmittel ist jeweils möglich, insbesondere von Gemischen aliphatischer Kohlenwasserstoffe. Bevorzugt sind *n*-Pentan, *n*-Hexan, *i*-Hexan und *n*-Decan sowie mögliche Gemische.

Eine weitere Ausführungsform des beanspruchten Verfahrens sieht vor, dass das Lösungsmittel S_{R} und das Lösungsmittel S_{X} mischbar oder identisch sind.

Ein molares Verhältnis E(X)₂R : hydridisches Reduktionsmittel wird so gewählt, dass die zwei Halogenidanionen X⁻ durch zwei Hydridionen H⁻ ersetzt werden. Bevorzugt ist das molare Verhältnis E(X)₂R : hydridisches Reduktionsmittel ≤ 1.

In einer Ausführungsform des beanspruchten Verfahrens zur Herstellung einer Verbindung gemäß der allgemeinen Formel (R)EH₂ (III) wird das hydridische Reduktionsmittel *in situ* hergestellt durch eine Reaktion von NaAlH₄ mit einem Glycolether. Dabei beträgt ein molares Verhältnis NaAlH₄ : Glycolether 1 : 2, also 0,5.

Im Zusammenhang mit der vorliegenden Erfindung bedeutet der Ausdruck *"in situ* hergestellt", dass die Edukte, welche zur Synthese einer auf diese Weise herzustellenden Verbindung erforderlich sind, in einer geeigneten Stöchiometrie in einem Lösungsmittel oder Lösungsmittelgemisch zur Reaktion gebracht werden und das dabei entstehende Produkt nicht isoliert wird. Vielmehr wird die Lösung oder die Suspension, welches die *in situ* erzeugte Verbindung umfasst, in der Regel direkt, d. h. ohne weitere Aufreinigung, weiterverwendet.

In einer weiteren Ausführungsform des Verfahrens zur Herstellung einer Verbindung gemäß der allgemeinen Formel (R)EH₂ (III) ist der Glycolether ausgewählt aus der Gruppe bestehend aus einem Monoethylenglycolmonoether, einem Diethylenglycolmonoether, einem Triethylengylcolmonoether, einem Monopropylenglycolmonoether, einem Dipropylenglycolmonoether und einem Tripropylenglycolmonoether. Bevorzugt eingesetzt wird ein Monoethylenglycolmonoether oder ein Diethylenglycolmonoether, besonders bevorzugt Ethylenglycolbutylether oder Diethylenglykolmonobutylether. Vorteilhaft bei einem Diethylenglycolmonoether, insbesondere solchen, bei denen die endständige Alkylgruppe wenigstens vier Kohlenstoffatome umfasst, ist deren vergleichsweise bessere Löslichkeit in aliphatischen Kohlenwasserstoffen. Letztere kommen bei dem hier beanspruchten Verfahren bevorzugt als Lösungsmittel zum Einsatz, insbesondere *n*-Pentan, *n*-Hexan, *n*-Heptan, *n*-Octan, *n*-Nonan, *n*-Decan, *n*-Undecan und *n-*Dodecan sowie deren Isomere. Zudem finden Cyclopentan, Cyclohexan, Cycloheptan, 1-Penten, 1-Hexen, 1-Hepten, 1-Octen, 1-Nonen, 1-Decen, 1-Undecen, 1-Dodecen, Cyclohexen, Benzol, Toluol und Xylol, sowie deren Isomere.

In einer anderen Variante des Verfahrens zur Herstellung einer Verbindung gemäß der allgemeinen Formel (R)EH₂ (III) ist das hydridische Reduktionsmittel Natrium-bis(2-methoxy-ethoxy)-aluminium-dihydrid oder Lithiumaluminiumhydrid. Mithin handelt es sich um ein kommerziell erhältliches hydridisches Reduktionsmittel. Natrium-bis(2-methoxy-ethoxy)-aluminium-dihydrid ist ein Dihydrido-dialkoxy-aluminat und auch bekannt als Synhydrid, Red-Al® und Vitrid®. Dieses Reduktionsmittel ist in Form einer viskosen, toluolischen Lösung kommerziell erhältlich, wobei ein ungefährer Gewichtsanteil von > 60w% angegeben wird.

Die Aufgabe wird zudem gelöst durch die Verwendung einer Verbindung AlR₃ als eine Präkursorverbindung zur Herstellung einer Aluminiumschicht oder einer Aluminium enthaltenden Schicht auf einer Oberfläche eines Substrats. Die zu verwendende Verbindung AlR₃ ist erhalten oder erhältlich nach einem Verfahren zur Übertragung wenigstens eines Restes R auf eine Verbindung gemäß der allgemeinen Formel E(X)_{q}, wobei X = Halogen, insbesondere X = F, Cl oder Br, und q = 2, 3 oder 4, unter Verwendung eines Lithiumalkylaluminats gemäß der allgemeinen Formel Li[AlR₄] (I), gemäß einem der weiter oben beschriebenen Ausführungsbeispiele. Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren.

Bei der vorgenannten Verwendung einer Verbindung AlR₃ als Präkursorverbindung handelt es sich um ein Verfahren zur Herstellung einer Aluminiumschicht oder einer Aluminium enthaltenden Schicht auf einer Oberfläche eines Substrats unter Verwendung einer Verbindung AlR₃. Die zu verwendende Verbindung AlR₃ ist erhalten oder erhältlich nach einem Verfahren zur Übertragung wenigstens eines Restes R auf eine Verbindung gemäß der allgemeinen Formel E(X)_{q}, wobei X = Halogen, insbesondere X = F, Cl oder Br, und q = 2, 3 oder 4, unter Verwendung eines Lithiumalkylaluminats gemäß der allgemeinen Formel Li[AlR₄] (I), gemäß einem der weiter oben beschriebenen Ausführungsbeispiele. Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. Das Verfahren umfasst die Schritte:
a) Zurverfügungstellung der Verbindung AlR₃
   und
b) Abscheidung der Aluminium-Schicht oder der Aluminium enthaltenden Schicht auf der Oberfläche des Substrats.

Der Begriff Schicht ist gleichbedeutend mit dem Ausdruck Film und trifft keine Aussage über die Schichtdicke oder die Filmdicke. Als Substrat können z. B. Korundfolien oder dünne metallische Folien eingesetzt werden. Das Substrat kann selbst Teil eines Bauteils sein. Die Abscheidung der Aluminium-Schicht oder der Aluminium enthaltenden Schicht kann mittels eines Gasphasenepitaxieverfahrens oder Gasphasenabscheidungsverfahren,
wie z. B. Atomlagenabscheidung oder chemischer Gasphasenabscheidung, erfolgen.

Die verwendeten Verbindungen AlR₃ sind aufgrund ihrer hohen Reinheit besonders gut als Präkursoren zur Herstellung qualitativ hochwertiger Aluminium-Schichten oder Aluminium enthaltender Schichten geeignet. Insbesondere sind sie frei von Verunreinigungen durch anorganische Salze und Sauerstoff, welche für den Beschichtungsprozess und damit für die Performance der beschichteten Substrate nachteilig sind. Das Nichtvorhandensein von Sauerstoffspuren ist unter anderem darauf zurückzuführen, dass - im Unterschied zu literaturbekannten Synthesevorschriften - sowohl bei der Darstellung der Edukte Li[AlR₄] (I) als auch im Rahmen der Herstellung von Verbindungen AlR₃ auf etherische Lösungsmittel verzichtet wird.

In einer Ausführungsform der Verwendung einer Verbindung AlR₃ als Präkursorverbindung beziehungsweise des Verfahrens zur Herstellung einer Aluminiumschicht oder einer Aluminium enthaltenden Schicht auf einer Oberfläche eines Substrats unter Verwendung einer Verbindung AlR₃ ist das Substrat ein Wafer. Der Wafer kann Silicium, Siliciumcarbid, Germanium, Galliumarsenid, Indiumphosphid, ein Glas, wie z. B. SiO₂, und/oder einen Kunststoff, wie z. B. Silikon, umfassen oder vollständig aus einem oder mehreren dieser Materialien bestehen. Zudem kann der Wafer eine oder mehrere Waferschichten mit jeweils einer Oberfläche aufweisen. Die Herstellung der Aluminium-Schicht oder der Aluminium enthaltenden Schicht kann auf der Oberfläche einer oder mehrerer Waferschichten vorgesehen sein.

Die Aufgabe wird weiterhin gelöst durch ein Substrat, welches auf einer Oberfläche eine Aluminium-Schicht oder eine Aluminium enthaltende Schicht aufweist, wobei die Aluminium-Schicht oder die Aluminium enthaltende Schicht herstellbar ist unter Verwendung einer Verbindung AlR₃, erhalten oder erhältlich nach einem Verfahren zur Übertragung wenigstens eines Restes R auf eine Verbindung gemäß der allgemeinen Formel E(X)_{q}, wobei X = Halogen, insbesondere X = F, Cl oder Br, und q = 2, 3 oder 4, unter Verwendung eines Lithiumalkylaluminats gemäß der allgemeinen Formel Li[AlR₄] (I), gemäß einem der weiter oben beschriebenen Ausführungsbeispiele. Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren.

Der Begriff Schicht ist gleichbedeutend mit dem Ausdruck Film und trifft keine Aussage über die Schichtdicke oder die Filmdicke. Als Substrat können z. B. Korundfolien oder dünne metallische Folien eingesetzt werden. Das Substrat kann selbst Teil eines Bauteils sein. Die Abscheidung der Aluminium-Schicht oder der Aluminium enthaltenden Schicht kann mittels eines Gasphasenepitaxieverfahrens oder Gasphasenabscheidungsverfahren,
wie z. B. Atomlagenabscheidung oder chemischer Gasphasenabscheidung, erfolgt sein.

Die verwendeten Verbindungen AlR₃ sind aufgrund ihrer hohen Reinheit besonders gut als Präkursoren zur Herstellung qualitativ hochwertiger Aluminium-Schichten und Aluminium enthaltender Schichten geeignet. Insbesondere sind sie frei von Verunreinigungen durch anorganische Salze und Sauerstoff, welche für den Beschichtungsprozess und damit für die Performance der beschichteten Substrate nachteilig sind. Das Nichtvorhandensein von Sauerstoffspuren ist unter anderem darauf zurückzuführen, dass - im Unterschied zu literaturbekannten Synthesevorschriften - sowohl bei der Darstellung der Edukte Li[AlR₄] (I) als auch im Rahmen der Herstellung von Verbindungen AlR₃ auf etherische Lösungsmittel verzichtet wird.

In einer Ausführungsform ist das Substrat ein Wafer. Der Wafer kann Silicium, Siliciumcarbid, Germanium, Galliumarsenid, Indiumphosphid, ein Glas, wie z. B. SiO₂, und/oder einen Kunststoff, wie z. B. Silikon, umfassen oder vollständig aus einem oder mehreren dieser Materialien bestehen. Zudem kann der Wafer eine oder mehrere Waferschichten mit jeweils einer Oberfläche aufweisen. Die Aluminium-Schicht oder die Aluminium enthaltende Schicht kann auf der Oberfläche einer oder mehrerer Waferschichten vorgesehen sein.

Weiterhin wird die Aufgabe gelöst durch ein Verfahren zur Herstellung von Lithiumalkylaluminaten gemäß der allgemeinen Formel Li[AlR₄] (I). Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren.

Das Verfahren umfasst den Schritt:
Umsetzung von LiAlH₄ mit einer Verbindung gemäß der allgemeinen Formel RLi,
   wobei
R ausgewählt ist aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
wobei
- R^{A} ausgewählt ist aus der Gruppe bestehend aus einem Alkylenrest (C1 - C6) und einem teilweise oder vollständig halogenierten Alkylenrest (C1 - C6),
- die Reste R^{B} unabhängig voneinander ausgewählt sind aus der Gruppe bestehend aus einem Alkylrest (C1 - C10), einem teilweise oder vollständig halogenierten Alkylrest (C1 - C10) und einem Alkyletherrest O-R^{E},
wobei die Reste R^{E} unabhängig voneinander ausgewählt sind aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren, in wenigstens einem aprotischen Lösungsmittel in einem Reaktionsbehältnis,
wobei ein molares Verhältnis LiAlH₄ : RLi ≥ 0,25 ist.

Das aprotische Lösungsmittel kann auch ein Lösungsmittelgemisch sein. Mithin kann das aprotische Lösungsmittel beispielsweise zwei oder mehr aprotische Lösungsmittel umfassen.

Der Begriff Reaktionsbehältnis ist nicht auf ein Volumen, eine Materialbeschaffenheit, eine Ausstattung oder eine Form beschränkt.

Das molare Verhältnis LiAlH₄ : RLi ist ≥ 1 : 4. Mithin beträgt das molare Verhältnis LiAlH₄ : RLi wenigstens ein Viertel, also 0,25.

Ein wesentlicher Vorteil des beanspruchten Verfahrens zur Herstellung von Lithiumalkylaluminaten gemäß der allgemeinen Formel Li[AlR₄] (I) besteht darin, dass vom kommerziell erhältlichen Edukt LiAlH₄ ausgegangen wird. Dies ist vergleichsweise kostengünstig zu beziehen und gut handhabbar. Mithin wird vorteilhafterweise auf die - in der Regel präparativ aufwändige und damit zeit- und kostenintensive - Darstellung einer Aluminiumvorläuferverbindung verzichtet. Zudem ist die Reinheit des eingesetzten LiAlH₄ lediglich für die Ausbeute entscheidend, hat aber üblicherweise keinen Einfluss auf die Reinheit des jeweiligen Produktes Li[AlR₄] (I). Insbesondere dann nicht, wenn eine Isolierung erfolgt. Denn dann werden das während der Reaktion ausgefallene LiH sowie gegebenenfalls aus dem Edukt LiAlH₄ stammende Verunreinigungen durch eine einfache Filtration abgetrennt. Das gewünschte Produkt wird durch Entfernen des Lösungsmittels des Filtrats im Feinvakuum (10⁻³ mbar) erhalten. Anstatt einer Filtration kann auch eine Abtrennung des während der Reaktion ausgefallenen LiH sowie gegebenenfalls aus dem Edukt LiAlH₄ stammender Verunreinigungen durch Dekantieren vorgesehen sein. Das Produkt wird dann ebenfalls durch Entfernen des Lösungsmittels des Filtrats im Feinvakuum (10⁻² - 10⁻³ mbar) isoliert. Mithin sieht das beanspruchte Verfahren eine Isolierung ohne aufwändige Aufreinigungsschritte, wie z. B. eine Umkristallisation, oder ein zeit-, energie- und kostenintensives Austreiben eines im Produkt gebundenen Lösungsmittels vor. Dadurch ist das Verfahren vergleichsweise einfach, rasch und kostengünstig durchführbar. Das isolierte Produkt Li[AlR₄] (I) kann zur Herstellung einer Stammlösung in einem aprotischen Lösungsmittel, beispielsweise einem aliphatischen Kohlenwasserstoff, verwendet werden. Eine solche Stammlösung kann dann, ohne weitere Vorbereitungen, für etwaige Umsetzungen, wie z. B. die Alkylierung eines Element- oder Metallhalogenids, aufbewahrt und eingesetzt werden. Alternativ oder ergänzend kann das Filtrat, welches nach dem Entfernen des während der Reaktion ausgefallenen LiH sowie gegebenenfalls aus dem Edukt LiAlH₄ stammender Verunreinigungen vorliegt, als Stammlösung für weitere Umsetzungen aufbewahrt und eingesetzt werden.

Durch die Verwendung eines aprotischen, insbesondere nicht-etherischen, Lösungsmittels oder Lösungsmittelgemisches wird vorteilhafterweise ausgeschlossen, dass die mit dem beanspruchten Verfahren darstellbaren Zielverbindungen Li[AlR₄] (I) als Solvensaddukte, insbesondere als Etheraddukte, erhalten werden. Die mit dem beanspruchten Verfahren herstellbaren Verbindungen Li[AlR₄] (I) zeigen eine gute Löslichkeit in diversen nicht-etherischen, insbesondere in unpolaren Lösungsmitteln, wie z. B. den verschiedenen Isomeren von Pentan, Hexan und Decan. Mithin wird sowohl durch das Syntheseprotokoll des beanspruchten Verfahrens zur Herstellung von Verbindungen des Typs Li[AlR₄] (I) als auch mit Blick auf weitere Umsetzungen der Verbindungen Li[AlR₄] (I) verhindert, dass etwaige Folgeprodukte gegebenenfalls mit Ether beziehungsweise Sauerstoffspuren verunreinigt werden.

Das beanspruchte Verfahren zur Herstellung einer Verbindung gemäß der allgemeinen Formel Li[AlR₄] (I) sieht im einfachsten Fall vorteilhafterweise lediglich einen Reaktionsschritt vor. Denn im simpelsten Fall schließt sich direkt, d.h. ohne irgendeinen Reinigungsschritt, an die Darstellung einer Verbindung gemäß der allgemeinen Formel Li[AlR₄] (I) eine weitere Umsetzung an, z. B. eine selektive teilweise oder vollständige Alkylierung eines Element- oder Metallhalogenids. Dann liegt - gemäß der weiter oben genannten Definition - eine *in situ*-Erzeugung von Li[AlR₄] (I) vor. Mithin ist das gewünschte Endprodukt, z. B. ein teilweise oder vollständig alkyliertes Element- oder Metallhalogenid, vorteilhafterweise gegebenenfalls mittels einer Eintopfsynthese darstellbar.

Insgesamt werden durch das beanspruchte Verfahren zur Herstellung eines Lithiumalkylaluminats gemäß der allgemeinen Formel Li[AlR₄] (I) die Nachteile des Standes der Technik überwunden. Insbesondere wird auf die vorgelagerte Darstellung einer Aluminiumpräkursorverbindung, wie z. B. Al*t*Bu₃ x Et₂O (H. Lehmkuhl, Liebigs Ann. Chem. 1968, 719, 40 - 49) und Al*t*Bu₃ (W. Uhl, Z. Anorg. Allg. Chem. 1989, 570, 37 - 53), sowie auf koordinierende, insbesondere etherische, Solventien verzichtet. Das beanspruchte Verfahren ist einfach, kostengünstig und reproduzierbar durchführbar, wobei die gewünschten Zielverbindungen gemäß der allgemeinen Formel Li[AlR₄] (I) in hoher Reinheit und guter Ausbeute erhalten werden. Insgesamt ist das beanspruchte Verfahren aus (atom)ökonomischer und ökologischer als befriedigend zu bewerten.

In einer Ausführungsform des beanspruchten Verfahrens ist R ausgewählt aus der Gruppe bestehend aus Me, Et, *n*Pr, *i*Pr, nBu, *t*Bu, sBu, *i*Bu, CH(Me)(*i*Pr), CH(Me)(*n*Pr), CH(Et)₂, CH(Et)(Me)₂, CH₂C₆H₅, C₆H₅, CH₂SiMe₃, CH₂SiEt₃, CH₂Si(Me)₂(OMe), CH₂Si(Et)₂(OEt), CH₂Si(Me)(*t*Bu)(OMe), CH₂Si(*t*Bu)(C₆H₅)(O*t*Bu) und CH₂Si(*i*Pr)₂(O*i*Pr). Diese Lithiumalkylaluminate, wie z. B. von Li[Al*t*Bu₄] und Li[Al(CH₂SiMe₃)₄], sind mit dem beanspruchten Verfahren in guter Ausbeute und hoher Reinheit reproduzierbar solvensfrei, insbesondere etherfrei, darstellbar. Vorteilhaft ist zudem, dass eine teilweise Dissoziierung von Li[Al(*t*Bu)₄] in *t*BuLi und Al*t*Bu₃, wie von Lehmkuhl (Liebigs Ann. Chem. 1968, 719, 40 - 49) beobachtet wurde, bei der mit dem beanspruchten Verfahren erhaltenen Verbindung Li[Al(*t*Bu)₄], nicht erfolgte. Ob das mit dem beanspruchten Verfahren erhaltene Lithiumalkylaluminat Li[Al*t*Bu₄] durch freies *t*BuLi verunreinigt ist, kann laut Clayden und Yasin einfach und rasch durch Zugabe von Tetrahydrofuran geprüft werden. Denn freies *t*BuLi reagiert mit Tetrahydrofuran in einer Etherspaltungsreaktion unter Gasentwicklung. Li[Al(*t*Bu)₄] geht dagegen in Lösung. (J. Clayden, S. A. Yasin, New J. Chem. 2002, 26, 191 - 192) Die Alkylreste R der mit dem beanspruchten Verfahren herstellbaren Verbindungen gemäß der allgemeinen Formel Li[AlR₄] (I) sind vorteilhafterweise selektiv auf Element- oder Metallhalogenide übertragbar. So können z. B. bei Verwendung von Li[Al*t*Bu₄], je nach gewählten Reaktionsbedingungen, selektiv ein, zwei, drei oder vier *tert*-Butylreste übertragen werden.

Eine weitere Ausführungsform des beanspruchten Verfahrens zur Herstellung einer Verbindung gemäß der allgemeinen Formel Li[AlR₄] (I) sieht vor, dass die Umsetzung von LiAlH₄ mit der Verbindung RLi folgende Schritte umfasst:
i) Bereitstellen einer Lösung oder einer Suspension von LiAlH₄ in einem ersten Lösungsmittel S1,
ii) Hinzufügen der Verbindung RLi,
wobei während des Hinzufügens und/oder nach dem Hinzufügen von RLi eine Reaktion von LiAlH₄ mit der Verbindung RLi erfolgt.

Dabei kann das erste Lösungsmittel S1 auch ein Lösungsmittelgemisch sein, also zwei oder mehr Lösungsmittel umfassen.

In einer weiteren Ausführungsform des beanspruchten Verfahrens wird in Schritt ii) die Verbindung RLi in einem zweiten Lösungsmittel S2 suspendiert oder gelöst hinzugefügt wird. Dies kann - in Abhängigkeit von den übrigen Reaktionsparametern - zur besseren Kontrolle des Reaktionsverlaufs bzw. der Exothermie vorteilhaft sein. Das Hinzufügen des Lithiumalkyls RLi als Lösung oder Suspension in dem zweiten Lösungsmittel S2 erfolgt beispielsweise unter Verwendung einer Dosiervorrichtung, insbesondere durch Zutropfen oder Zuspritzen. Alternativ oder ergänzend kann in einer Zuleitung des Reaktionsbehältnisses ein Absperrventil und/oder ein Absperrhahn vorgesehen sein.

Eine weitere Ausführungsform des beanspruchten Verfahrens sieht vor, dass das zweite Lösungsmittel S2 mit dem ersten Lösungsmittel S1 mischbar oder identisch ist. Die im Zusammenhang mit dieser Erfindung geltende Definition des Begriffes "mischbar" ist weiter oben angegeben.

In einer noch anderen Ausführungsform des beanspruchten Verfahrens zur Herstellung einer Verbindung gemäß der allgemeinen Formel Li[AlR₄] (I) wird LiAlH₄ als Feststoff bereitgestellt beziehungsweise vorgelegt. Dann erfolgt das Hinzufügen von RLi als Lösung oder Suspension in dem zweiten Lösungsmittel S2, beispielsweise durch Zutropfen oder Zuspritzen.

Eine weitere Ausführungsform des beanspruchten Verfahrens sieht vor, dass in einem ersten Schritt eine Lösung oder Suspension von RLi in einem ersten Lösungsmittel S1 bereitgestellt beziehungsweise vorgelegt wird. In einem zweiten Schritt erfolgt das Hinzufügen von LiAlH₄ als Feststoff oder als Suspension oder Lösung in einem zweiten Lösungsmittel S2. Dabei sind das erste Lösungsmittel S1 und das zweite Lösungsmittel S2 mischbar; sie können aber auch identisch sein.

Je nach Wahl des Lösungsmittels oder Lösungsmittelgemisches sowie der übrigen Reaktionsbedingungen, wie z. B. Zugabeform von RLi, d. h. als Substanz bzw. Feststoff oder gelöst in dem zweiten Lösungsmittel S2, Geschwindigkeit des Hinzufügens von RLi, Rührgeschwindigkeit, Innentemperatur des Reaktionsbehältnisses, erfolgt die Reaktion von LiAlH₄ mit dem Lithiumalkyl RLi bereits während des Hinzufügens und/oder nach dem Hinzufügen von RLi.

Eine weitere Variante des beanspruchten Verfahrens zur Herstellung einer Verbindung gemäß der allgemeinen Formel Li[AlR₄] (I) sieht vor, dass das erste Lösungsmittel S1 und das zweite Lösungsmittel S2 unabhängig voneinander ausgewählt sind aus der Gruppe bestehend aus Kohlenwasserstoffen, Benzol und Benzolderivaten. Beispielsweise sind das erste Lösungsmittel S1 und das zweite Lösungsmittel S2 unabhängig voneinander ausgewählt aus der Gruppe bestehend aus *n*-Pentan, *n*-Hexan, *n*-Heptan, *n*-Octan, *n*-Nonan, *n*-Decan, *n*-Undecan, *n*-Dodecan, Cyclopentan, Cyclohexan, Cycloheptan, 1-Penten, 1-Hexen, 1-Hepten, 1-Octen, 1-Nonen, 1-Decen, 1-Undecen, 1-Dodecen, Cyclohexen, Benzol, Toluol und Xylol, sowie deren Isomeren. Es ist auch möglich, dass das Lösungsmittel S1 und/oder das Lösungsmittel S2 jeweils zwei oder mehr Lösungsmittel umfassen, insbesondere jeweils als ein Gemisch aliphatischer Kohlenwasserstoffe vorliegen. Die Wahl des Lösungsmittels oder des Lösungsmittelgemisches ist unter anderem abhängig von einer sich gegebenenfalls unmittelbar anschließenden weiteren Umsetzung des hergestellten Lithiumalkylaluminats Li[AlR₄] (I), d. h. ohne irgendeinen vorherigen Aufreinigungs- und/oder Isolierungsschritt. Es kann auch vorgesehen sein, die Reaktionsmischung, welche das Lithiumalkylaluminats Li[AlR₄] (I) umfasst, für eine spätere Weiterverwendung aufzubewahren. Alternativ werden das bei der Herstellung des jeweiligen Lithiumalkylaluminats Li[AlR₄] (I) angefallene LiH sowie etwaige aus den Edukten stammende Verunreinigungen durch Filtration oder Dekantieren abgetrennt. Das Filtrat wird dann beispielsweise sofort weiter umgesetzt oder als Stammlösung aufbewahrt. In allen vorgenannten Fällen ist es vorteilhaft, bereits während der Planung der Darstellung des jeweiligen Lithiumalkylaluminats Li[AlR₄] (I) dessen weiteren Verwendungsmöglichkeiten zu bedenken. Sind beispielsweise Alkylierungen von Element- oder Metallhalogeniden geplant, sind bevorzugte Lösungsmittel *n*-Pentan, *n*-Hexan, *i*-Hexan und *n*-Decan mögliche Gemische. Die Verwendung eines vergleichsweise hochsiedenden Lösungsmittels, z. B. von *n-*Decan, oder eines relativ hochsiedenden Lösungsmittelgemisches ist besonders vorteilhaft, wenn die jeweilige alkylierte Zielverbindung destillativ abtrennbar ist. Denn dadurch ist die Abtrennung der bei der Umsetzung als Nebenprodukt angefallenen Salzfracht besonders einfach quantitativ möglich. Sie verbleibt nämlich nach Abschluss der Destillation als Rückstand im Reaktionsgefäß.

In einer weiteren Ausführungsform des beanspruchten Verfahrens wird die Umsetzung von LiAlH₄ mit der Verbindung RLi bei einer Innentemperatur Tu des Reaktionsbehältnisses durchgeführt, wobei die Innentemperatur T_{U} zwischen -30 °C und 100 °C beträgt. Wegen der Exothermie der Reaktion kann es von Vorteil sein, die Geschwindigkeit des Hinzufügens von RLi und/oder die Innentemperatur T_{U} des Reaktionsbehältnisses vergleichsweise niedrig zu wählen. Alternativ oder ergänzend kann vorgesehen sein, dass eine Lösung oder Suspension von RLi in dem zweiten Lösungsmittel S2 oder Lösungsmittelgemisch hinzugefügt wird. Die jeweilige Vorgehensweise ist unter Berücksichtigung der übrigen Reaktionsparameter, wie z. B. der LiAlH₄-Konzentration und des Lösungsmittels oder Lösungsmittelgemisches, zu wählen.

Eine Innentemperatur des Reaktionsbehältnisses kann mithilfe eines Temperatursensors oder mehrerer Temperatursensoren für einen Bereich oder mehrere Bereiche des Reaktionsgefäßes ermittelt werden. Dabei ist zumindest ein Temperatursensor für die Ermittlung der Innentemperatur T_{U} vorgesehen, welche in der Regel einer Durchschnittstemperatur T_{D11} des Reaktionsgemisches entspricht.

In einer anderen Variante des beanspruchten Verfahrens zur Herstellung einer Verbindung gemäß der allgemeinen Formel Li[AlR₄] (I) beträgt die Innentemperatur T_{U} des Reaktionsbehältnisses zwischen -15 °C und 80 °C. In einer weiteren Variante beträgt die Innentemperatur T_{U} des Reaktionsbehältnisses während der Umsetzung von LiAlH₄ mit der Verbindung RLi zwischen -10 °C und 50 °C.

In einer weiteren Ausführungsform des beanspruchten Verfahrens wird die Innentemperatur T_{U} des Reaktionsbehältnisses unter Verwendung eines Wärmeträgers W_{U} geregelt und/oder gesteuert wird. Dazu kann beispielsweise ein Kryostat verwendet werden, welcher einen Wärmeträger beinhaltet, der idealerweise sowohl als Kühlmittel als auch als Wärmemittel fungieren kann. Durch den Einsatz des Wärmeträgers W_{U} können Abweichungen der Innentemperatur T_{U} von einem für die Umsetzung von LiAlH₄ mit RLi festgelegten Sollwert T_{S11} weitestgehend abgefangen bzw. kompensiert werden. Die Realisierung einer konstanten Innentemperatur T_{U} ist aufgrund der üblichen Geräteabweichungen kaum möglich. Durch die Verwendung des Wärmeträgers W_{U} kann die Umsetzung von LiAlH₄ mit RLi aber zumindest in einem vorgewählten Temperaturbereich oder in mehreren vorgewählten Temperaturbereichen durchgeführt werden. So kann es beispielsweise - in Abhängigkeit von den übrigen Reaktionsparametern - zur noch besseren Kontrolle des Reaktionsverlaufs bzw. der Exothermie vorteilhaft sein, ein Temperaturprogramm zu erstellen. Dabei kann zum Beispiel während einer ersten Phase des Hinzufügens von RLi eine niedrigere Temperatur bzw. ein niedrigerer Temperaturbereich gewählt werden als in einer zweiten Phase des Hinzufügens von RLi. Es können auch mehr als zwei Phasen des Hinzufügens und damit mehr als zwei vorgewählte Temperaturen bzw. Temperaturbereiche vorgesehen sein. Je nach Wahl der übrigen Reaktionsbedingungen, wie z. B. der LiAlH₄-Konzentration und des Lösungsmittels oder Lösungsmittelgemisches, kann es während des Hinzufügens und/oder nach dem Hinzufügen von LiR günstig sein, eine, gegebenenfalls auch schrittweise, Erniedrigung der Innentemperatur T_{U} des Reaktionsbehältnisses unter Verwendung des Wärmeträgers W_{U} durchzuführen. Dadurch kann unter Umständen sichergestellt werden, dass die Umsetzung von LiAlH₄ mit RLi langsamer und damit kontrollierter, insbesondere hinsichtlich der Wärmetönung, erfolgt. Im Anschluss an eine Erniedrigung der Innentemperatur T_{U} des Reaktionsbehältnisses kann eine, auch schrittweise, Erhöhung der Innentemperatur T_{U} vorgesehen sein, damit die Umsetzung von LiAlH₄ mit RLi vervollständigt wird

In einer noch anderen Ausführungsform des beanspruchten Verfahrens zur Herstellung einer Verbindung gemäß der allgemeinen Formel Li[AlR₄] (I) beträgt eine Innentemperatur T_{H} des Reaktionsbehältnisses während des Hinzufügens und/oder nach dem Hinzufügen der Verbindung RLi zwischen -40 °C und 80 °C. In einer weiteren Variante beträgt die Innentemperatur T_{H} des Reaktionsbehältnisses während des Hinzufügens und/oder nach dem Hinzufügen der Verbindung RLi zwischen -30 °C und 50 °C. In einer noch anderen Variante beträgt die Innentemperatur T_{H} des Reaktionsbehältnisses während des Hinzufügens und/oder nach dem Hinzufügen der Verbindung RLi zwischen -20°C und 35 °C. Dabei ist zumindest ein Temperatursensor für die Ermittlung der Innentemperatur T_{H} vorgesehen, welche in der Regel einer Durchschnittstemperatur T_{D22} des Reaktionsgemisches entspricht. Der Temperatursensor kann identisch mit demjenigen für die Ermittlung der Innentemperatur T_{U} sein.

In einer weiteren Ausführungsform des beanspruchten Verfahrens wird die Innentemperatur T_{H} des Reaktionsgefäßes unter Verwendung eines Wärmeträgers W_{H} geregelt und/oder gesteuert. Dazu kann beispielsweise ein Kryostat verwendet werden, welcher einen Wärmeträger beinhaltet, der idealerweise sowohl als Kühlmittel als auch als Wärmemittel fungieren kann. Durch den Einsatz des Wärmeträgers W_{H} können Abweichungen der Innentemperatur T_{H} von einem für die Zeit während des Hinzufügens und/oder nach dem Hinzufügen von RLi festgelegten Sollwert T_{S22} weitestgehend abgefangen bzw. kompensiert werden. Die Realisierung einer konstanten Innentemperatur T_{H} ist aufgrund der üblichen Geräteabweichungen kaum möglich. Durch die Verwendung des Wärmeträgers W_{H} kann die Umsetzung von LiAlH₄ mit RLi aber zumindest in einem vorgewählten Temperaturbereich oder in mehreren vorgewählten Temperaturbereichen durchgeführt werden. So kann es beispielsweise - in Abhängigkeit von den übrigen Reaktionsparametern - zur noch besseren Kontrolle des Reaktionsverlaufs bzw. der Exothermie vorteilhaft sein, ein Temperaturprogramm zu erstellen. Dabei kann zum Beispiel während einer ersten Phase des Hinzufügens von RLi eine niedrigere Temperatur bzw. ein niedrigerer Temperaturbereich gewählt werden als in einer zweiten Phase des Hinzufügens von RLi. Es können auch mehr als zwei Phasen des Hinzufügens und damit mehr als zwei vorgewählte Temperaturen bzw. Temperaturbereiche vorgesehen sein.

Eine noch andere Ausführungsform des beanspruchten Verfahrens sieht vor, dass nach dem Schritt, umfassend die Umsetzung von LiAlH₄ mit der Verbindung RLi, ein weiterer Schritt durchgeführt wird, welcher eine Isolierung von Li[AlR₄] (I) umfasst:
i) als Lösung,
   welche Li[AlR₄] (I) und das wenigstens eine aprotische Lösungsmittel umfasst,
   oder
ii) als Feststoff.

Das aprotische Lösungsmittel kann auch zwei oder mehr Lösungsmittel umfassen.

Die nach vollständiger Umsetzung von LiAlH₄ mit RLi vorliegende Reaktionsmischung, umfassend ein Lithiumalkylaluminat gemäß der allgemeinen Formel Li[AlR₄] (I), kann unmittelbar, d. h. ohne irgendeinen vorgeschalteten Aufreinigungsschritt, einer weiteren Reaktion unterworfen oder zur späteren Verwendung aufbewahrt werden. Die Reaktionsmischung weist neben dem jeweils dargestellten Lithiumalkylaluminat gemäß der allgemeinen Formel Li[AlR₄] (I) üblicherweise nur ein definiertes, während des Herstellungsprozesses angefallenes Nebenprodukt auf, nämlich LiH. Gegebenenfalls sind zudem aus den Edukten stammende Verunreinigungen vorhanden. Im Folgenden wird die nach vollständiger Umsetzung von LiAlH₄ mit RLi vorliegende Reaktionsmischung vereinfachend auch als Suspension bezeichnet.

Alternativ erfolgt die Isolierung der Verbindung Li[AlR₄] (I) i) als Lösung, welche Li[AIR4] (I) und das aprotische Lösungsmittel umfasst, oder ii) als Feststoff. Die Isolierung kann jeweils einen oder mehrere Schritte umfassen.

In einer Variante des beanspruchten Verfahrens umfasst die Isolierung einen Filtrationsschritt. Dabei können auch mehrere Filtrationsschritte vorgesehen sein, gegebenenfalls auch eine oder mehrere Filtrationen über einem Reinigungsmedium, wie z. B. Aktivkohle oder Silica, z. B. Celite®. Der Filterkuchen, welcher das während der Reaktion ausgefallene LiH und gegebenenfalls aus den Edukten stammende Verunreinigungen umfasst, kann mit einer geringen Menge eines relativ leicht flüchtigen Lösungsmittels, wie z. B. *n*-Pentan, *n-*Hexan oder *i*-Hexan, gewaschen werden, um eventuell darin enthaltenes Produkt Li[AlR₄] (I) zu extrahieren. Als Alternative zu einer Filtration kann ein Dekantieren vorgesehen sein. Dadurch kann die Lösung, welche die gewünschte Zielverbindung umfasst, ebenfalls von dem während der Reaktion ausgefallenen LiH und gegebenenfalls aus den Edukten stammenden Verunreinigungen abgetrennt werden. Zusätzlich kann der zurückbleibende Feststoff mit einer geringen Menge eines relativ leicht flüchtigen Lösungsmittels, wie z. B. *n-*Pentan, *n*-Hexan oder *i*-Hexan, gewaschen beziehungsweise darin gegebenenfalls enthaltenes Produkt extrahiert werden. Diese Isolierungsschritte können unabhängig davon vorgesehen sein, ob Li[AlR₄] (I) als i) Lösung in dem aprotischen Lösungsmittel oder als ii) Feststoff isoliert und dann gelagert und/oder weiterverwendet werden soll.

Die Isolierung kann weitere Verfahrensschritte umfassen, wie z. B. die Reduzierung des Volumens der Mutterlauge, d. h. Einengen, z. B. mittels "bulb-to-bulb", die Zugabe eines Lösungsmittels und/oder einen Lösungsmittelaustausch, um eine Fällung des Produktes aus der Mutterlauge zu erzielen und/oder Verunreinigungen und/oder Edukte zu entfernen, Waschen und Trocknen, auch Gefriertrocknen, des Produktes, eine Kondensation, eine Destillation und/oder eine Sublimation.

Wenn die Isolierung von Li[AlR₄] (I) als i) Lösung vorgesehen ist, welche Li[AlR₄] (I) und das aprotische Lösungsmittel umfasst, kann die Lösung, welche beispielsweise durch einen Filtrationsschritt oder Dekantieren erhalten wurde, sofort weiter umgesetzt und/oder als Stammlösung aufbewahrt werden. Verwendung findet eine solche Stammlösung z. B. für Alkylierungen von Element- oder Metallhalogeniden, welche unter anderem in nicht-etherischen, aprotischen Lösungsmitteln wie, z. B. n-Pentan, n-Hexan, *i*-Hexan und *n*-Decan sowie mögliche Gemische davon, durchführbar sind.

Ist die Isolierung von Li[AlR₄] (I) als ii) Feststoff vorgesehen, so kann dieser ebenfalls direkt weiter umgesetzt und/oder gelagert werden. Zudem kann die isolierte Verbindung Li[AlR₄] (I) zur Herstellung einer definierten Stammlösung in einem Lösungsmittel verwendet werden. Dabei ist das für die Stammlösung gewählte Lösungsmittel von dem für die Herstellung von Li[AlR₄] (I) eingesetzten verschieden.

Die Aufgabe wird zudem gelöst durch eine Lösung, umfassend ein Lithiumalkylaluminat gemäß der allgemeinen Formel Li[AlR₄] (I) und wenigstens ein aprotisches Lösungsmittel, erhältlich nach einem Verfahren zur Herstellung einer Verbindung gemäß der allgemeinen Formel Li[AlR₄] (I) gemäß einem der weiter oben beschriebenen Ausführungsbeispiele. Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren.

Die Lösung ist mittels des weiter oben beschriebenen Verfahrens einfach, kostengünstig und reproduzierbar darstellbar. Dies ist insbesondere für eine industrielle Anwendung vorteilhaft. Anwendung findet die Lösung beispielsweise in der selektiven Alkylierung von Element- oder Metallhalogeniden. Die Verbindungen des Typs Li[AlR₄] (I) zeichnen sich insbesondere dadurch aus, dass selektiv einer, zwei, drei oder alle vier Reste R übertragbar sind. Die beanspruchte Lösung kann entweder sofort nach ihrer Herstellung weiter umgesetzt und/oder als Stammlösung aufbewahrt werden. Die Lösung ist - ausgehend von der nach vollständiger Umsetzung von LiAlH₄ mit RLi vorliegenden Suspension, umfassend ein Lithiumalkylaluminat gemäß der allgemeinen Formel Li[AlR₄] (I) und wenigstens ein aprotisches Lösungsmittel - gemäß einer Ausführungsform des weiter oben beschriebenen Verfahrens zur Herstellung eines Lithiumalkylaluminats gemäß der allgemeinen Formel Li[AlR₄] (I) durch eine Filtration oder ein Dekantieren erhältlich. Denn die Suspension weist üblicherweise nur ein definiertes, während des Herstellungsprozesses angefallenes Nebenprodukt auf, nämlich LiH, sowie gegebenenfalls Verunreinigungen des Edukts LiAlH₄. Etherische Verunreinigungen sind aufgrund des Verfahrens zur Herstellung der Lösung ausgeschlossen. Dies ist mit Blick auf eine Verwendung einer solchen Lösung, insbesondere für selektive Alkylierungen von Element- oder Metallhalogeniden, besonders günstig. Denn die Alkylierungsprodukte werden unter anderem als Präkursorverbindungen für Gasphasenabscheidungsverfahren eingesetzt. In Gegenwart von Sauerstoffspuren, welche beispielsweise auf die Verwendung etherischer Solventien in vorgelagerten Synthesen zurückgeführt werden können, werden mit diesen Verfahren gegebenenfalls unbrauchbare Metallschichten oder metallenthaltende Schichten hergestellt.

Ferner wird die Aufgabe gelöst durch Lithiumalkylaluminate gemäß der allgemeinen Formel Li[AlR₄] (I), erhältlich nach einem Verfahren zur Herstellung einer Verbindung gemäß der allgemeinen Formel Li[AlR₄] (I) gemäß einem der weiter oben beschriebenen Ausführungsbeispiele. Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. Dabei ist R^{A} ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren.

Die gemäß einem Ausführungsbeispiel des weiter oben beschriebenen Verfahrens erhältlichen Lithiumalkylaluminate des Typs Li[AlR₄] (I) sind, insbesondere ausgehend von den kommerziell erhältlichen Verbindungen LiAlH₄ und RLi, selektiv, einfach, kostengünstig und reproduzierbar in guten Ausbeuten und Reinheiten darstellbar. Mithin sind sie auch im industriellen Maßstab herstellbar. Aufgrund des gewählten Herstellungsverfahrens weisen die, in der Regel als Feststoffe oder Flüssigkeiten vorliegenden Verbindungen des Typs Li[AlR₄] (I), insbesondere keine Verunreinigungen durch anorganische Salze oder etherische Lösungsmittel auf.

Verbindungen des Typs Li[AlR₄] (I) eignen sich insbesondere als Transferreagenz zur Übertragung wenigstens eines der vier Reste R auf ein Element- oder Metallhalogenid. Denn mit Li[AlR₄] (I) als Transferreagenz sind vorteilhafterweise selektiv ein, zwei, drei oder vier Reste R übertragbar. Mithin ist unter Verwendung von Li[AlR₄] (I) auch die Darstellung heteroleptischer Komplexe möglich. Im Zusammenhang mit der vorliegenden Erfindung wird von der Synthese eines heteroleptischen Komplexes gesprochen, wenn lediglich ein Teil der Halogenidanionen des eingesetzten Element- oder Metallhalogenids durch jeweils einen Rest R ersetzt wird. Alternativ kann ein Teil der Halogenidanionen bereits vor der Umsetzung mit Li[AlR₄] (I) durch andere, von R verschiedene Liganden ausgetauscht worden sein. Weiterhin vorteilhaft ist, dass im Falle der Übertragung von vier Resten R ausgehend von einem Moläquivalent Li[AlR₄] (I) die anfallende Salzfracht - im Vergleich zum Einsatz eines Alkylierungsreagenzes, durch welches pro Moläquivalent lediglich ein Rest R übertragbar ist - deutlich verringert ist. In der Regel fällt ausschließlich LiAlX₄ als vergleichsweise einfach quantitativ abtrennbares Nebenprodukt an. Zudem sind Verbindungen gemäß der allgemeinen Formel Li[AlR₄] (I) in diversen nicht-etherischen organischen Lösungsmitteln herstellbar und zeigen eine gute Löslichkeit in ihnen, insbesondere in unpolaren Lösungsmitteln, wie z. B. den verschiedenen Isomeren von Pentan, Hexan und Decan. Dadurch wird - mit Blick auf eine weitere Umsetzung von Li[AlR₄] (I) - von vorneherein ausgeschlossen, dass das jeweilige Folgeprodukt, insbesondere ein Alkylierungsprodukt oder dessen Folgeprodukte, gegebenenfalls mit Ether beziehungsweise Sauerstoffspuren verunreinigt werden. Insbesondere hinsichtlich einer industriellen Anwendung ist bei der Verwendung von Li[AlR₄] (I) als Transferreagenz die - im Vergleich zu Umsetzungen mit gängigen Alkylierungsreagenzien - geringere Wärmetönung vorteilhaft. Dadurch werden nicht nur Energiekosten für die Kühlung eingespart, sondern es wird auch eine unter Sicherheitsaspekten günstigere Verfahrensführung ermöglicht.

Verbindungen gemäß der allgemeinen Formel Li[AlR₄] (I) können unmittelbar nach ihrer Isolierung weiter umgesetzt und/oder gelagert werden. Alternativ oder ergänzend kann die jeweilige Verbindung Li[AlR₄] (I) zur Herstellung einer definierten Stammlösung in einem unpolaren Lösungsmittel verwendet werden.

Die beanspruchten Lithiumalkylaluminate gemäß der allgemeinen Formel Li[AlR₄] (I) sind aus (atom)ökonomischer und ökologischer als befriedigend zu bewerten.

Des Weiteren wird die Aufgabe gelöst durch die Verwendung
a) eines Lithiumalkylaluminats gemäß der allgemeinen Formel Li[AlR₄] (I),
   oder
b) einer Lösung,
umfassend ein Lithiumalkylaluminat gemäß der allgemeinen Formel Li[AlR₄] (I)
und wenigstens ein aprotisches Lösungsmittel,
erhalten oder erhältlich nach einem Verfahren zur Herstellung einer Verbindung gemäß der allgemeinen Formel Li[AlR₄] (I) gemäß einem der weiter oben beschriebenen Ausführungsbeispiele,
als Transferreagenz zur Übertragung wenigstens einer Gruppe R, insbesondere auf eine Verbindung gemäß der allgemeinen Formel E(X)_{q}.

Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. E ist ausgewählt aus der Gruppe bestehend aus Aluminium, Gallium, Indium, Thallium, Germanium, Zinn, Blei, Antimon, Bismut, Zink, Cadmium, Quecksilber und Phosphor. Zudem gilt, dass X = Halogen, insbesondere X = F, Cl oder Br, und q = 2, 3 oder 4.

Bei der vorgenannten Verwendung eines Lithiumalkylaluminats gemäß der allgemeinen Formel Li[AlR₄] (I) oder einer Lösung, umfassend ein Lithiumalkylaluminat gemäß der allgemeinen Formel Li[AlR₄] (I) und wenigstens ein aprotisches Lösungsmittel, als Transferreagenz handelt es sich um Verfahren zur Übertragung wenigstens eines Restes R auf eine Verbindung gemäß der allgemeinen Formel E(X)_{q} zur Herstellung einer Verbindung gemäß der allgemeinen Formel E(X)_{q-p}Rₚ (II) unter Verwendung eines Lithiumalkylaluminats gemäß der allgemeinen Formel Li[AlR₄] (I). Insbesondere liegt das zu verwendende Lithiumalkylaluminat gemäß der allgemeinen Formel Li[AlR₄] (I) als Feststoff oder Flüssigkeit vor, erhalten oder erhältlich nach einem Verfahren zur Herstellung einer Verbindung gemäß der allgemeinen Formel Li[AlR₄] (I) gemäß einem der weiter oben beschriebenen Ausführungsbeispiele. Alternativ wird das zu verwendende Lithiumalkylaluminat gemäß der allgemeinen Formel Li[AlR₄] (I) als Lösung eingesetzt, umfassend ein Lithiumalkylaluminat gemäß der allgemeinen Formel Li[AlR₄] (I) und wenigstens ein aprotisches Lösungsmittel. Die Lösung ist jeweils ebenfalls erhalten oder erhältlich nach einem Verfahren zur Herstellung einer Verbindung gemäß der allgemeinen Formel Li[AlR₄] (I) gemäß einem der weiter oben beschriebenen Ausführungsbeispiele.

Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. E ist ausgewählt aus der Gruppe bestehend aus Aluminium, Gallium, Indium, Thallium, Germanium, Zinn, Blei, Antimon, Bismut, Zink, Cadmium, Quecksilber und Phosphor. Zudem gilt, dass X = Halogen, insbesondere X = F, Cl oder Br, q = 2, 3 oder 4 und p = 1, 2, 3 oder 4.

Das Verfahren umfasst die Schritte:
a) Zurverfügungstellung
   des Lithiumalkylaluminats gemäß der allgemeinen Formel Li[AlR₄] (I)
   oder
   einer Lösung, umfassend ein Lithiumalkylaluminat gemäß der allgemeinen Formel Li[AlR₄] (I) und wenigstens ein aprotisches Lösungsmittel,
   und
b) Umsetzung von E(X)_{q} mit dem Lithiumalkylaluminat Li[AlR₄] (I)
   in wenigstens einem aprotischen Lösungsmittel S_{A} in einem Reaktionsgefäß.

Das aprotische Lösungsmittel in Schritt a) kann auch ein Lösungsmittelgemisch sein. Mithin kann das aprotische Lösungsmittel zwei oder mehr aprotische Lösungsmittel umfassen. Das aprotische Lösungsmittel aus Schritt a) und das aprotische Lösungsmittel S_{A} aus Schritt b) sind mischbar; sie können aber auch identisch sein. Eine Definition für den Begriff "mischbar" ist weiter oben gegeben.

Der Begriff Reaktionsgefäß ist nicht auf ein Volumen, eine Materialbeschaffenheit, eine Ausstattung oder eine Form beschränkt.

Die Variable q ist abhängig von der Oxidationszahl des jeweiligen Elements E. Beispielsweise ist q = 2 im Falle von Zink, q = 3 im Falle von Aluminium und q = 4 im Falle von Zinn.

Mit dem beanspruchten Verfahren sind unter Verwendung von Li[AlR₄] (I) als Transferreagenz vorteilhafterweise selektiv ein, zwei, drei oder vier Reste R übertragbar. Mithin ist auch die Darstellung heteroleptischer Komplexe möglich. Im Zusammenhang mit der vorliegenden Erfindung wird von der Synthese eines heteroleptischen Komplexes gesprochen, wenn lediglich ein Teil der Halogenidanionen des eingesetzten Element- oder Metallhalogenids E(X)_{q} durch jeweils einen Rest R ersetzt wird. Alternativ kann ein Teil der Halogenidanionen bereits vor der Umsetzung mit Li[AlR₄] (I) durch andere, von R verschiedene Liganden ausgetauscht worden sein. Mithin ist das beanspruchte Verfahren zusätzlich zur selektiven Herstellung von Verbindungen des Typs E(X)_{q-p}Rₚ (II) auch für die selektive Darstellung einer Vielzahl von Verbindungen anwendbar, bei welchen ein Teil der Halogenidanionen durch andere Liganden als R ersetzt ist.

Besonders vorteilhaft bei der beanspruchten Verwendung von Li[AlR₄] (I) als Transferreagenz beziehungsweise dem beanspruchten Verfahren zur Übertragung wenigstens eines Restes R auf eine Verbindung gemäß der allgemeinen Formel E(X)_{q} unter Verwendung eines Lithiumalkylaluminats gemäß der allgemeinen Formel Li[AlR₄] (I) ist, dass insbesondere im Falle der Übertragung von vier Resten R ausgehend von einem Moläquivalent Transferreagenz die anfallende Salzfracht - im Vergleich zum Einsatz eines Alkylierungsreagenzes, durch welches pro Moläquivalent lediglich ein Rest R übertragbar ist - deutlich verringert wird. Denn in der Regel fällt ausschließlich LiAlX₄ als vergleichsweise einfach quantitativ abtrennbares Nebenprodukt an. Die Abtrennung kann z. B. mittels eines Filtrationsschrittes und/oder einer destillativen Abtrennung oder Kondensation einer flüchtigen Zielverbindung und/oder eines Lösungsmittels oder Lösungsmittelgemisches erfolgen. An die Kondensation schließt sich gegebenenfalls eine destillative Aufreinigung an. In Einzelfällen besteht die Salzfracht stattdessen aus LiX. Durch die Wahl des aprotischen Lösungsmittels ist die Abtrennung von LiX jedoch auch vergleichsweise einfach quantitativ möglich. Dazu kann ebenfalls ein Filtrationsschritt und/oder eine Abtrennung einer flüchtigen Zielverbindung und/oder eines Lösungsmittels oder Lösungsmittelgemisches mittels Destillation oder Kondensation vorgesehen sein. An letztere kann sich gegebenenfalls eine destillative Aufreinigung anschließen. Somit ist die Aufreinigung des jeweiligen Alkylierungsproduktes in der Regel besonders einfach und kostengünstig realisierbar. Dies ist mit Blick auf dessen Herstellung im industriellen Maßstab und dessen weitere Verwendung vorteilhaft. Ein weiterer Vorteil besteht darin, dass bei Verwendung von Li[AlR₄] (I) als Transferreagenz vollständig auf etherische Lösungsmittel verzichtet werden kann. Denn Li[AlR₄] (I) ist in diversen nicht-etherischen organischen Lösungsmitteln herstellbar und zeigt eine gute Löslichkeit in ihnen, insbesondere in unpolaren Lösungsmitteln, wie z. B. den verschiedenen Isomeren von Pentan, Hexan und Decan. Dadurch wird von vorneherein ausgeschlossen, dass das jeweilige Alkylierungsprodukt oder dessen Folgeprodukte gegebenenfalls mit Ether beziehungsweise Sauerstoffspuren verunreinigt werden. Insbesondere mit Blick auf eine industrielle Anwendung ist die - im Vergleich zu Umsetzungen mit gängigen Alkylierungsreagenzien - geringere Wärmetönung vorteilhaft. Dadurch werden nicht nur Energiekosten für die Kühlung eingespart, sondern es wird auch eine unter Sicherheitsaspekten günstigere Verfahrensführung ermöglicht.

Die mit dem beanspruchten Verfahren unter Verwendung von Li[AlR₄] (I) darstellbaren Verbindungen gemäß der allgemeinen Formel E(X)_{q-p}Rₚ (II) werden in guten bis sehr guten Ausbeuten, von z. T. > 80%, und in hoher Reinheit erhalten, wie weiter oben ausgeführt.

Die beanspruchte Verwendung beziehungsweise das beanspruchte Verfahren sieht im einfachsten Fall, nämlich einer *in situ*-Erzeugung des jeweiligen alkylierten Produktes für eine sich direkt anschließende weitere Umsetzung, vorteilhafterweise lediglich einen Umsetzungsschritt vor. Mithin ist das gewünschte Endprodukt vorteilhafterweise gegebenenfalls mittels einer Eintopfsynthese darstellbar.

Insgesamt werden durch die beanspruchte Verwendung eines Lithiumalkylaluminats gemäß der allgemeinen Formel Li[AlR₄] (I) als Transferreagenz beziehungsweise das beanspruchte Verfahren zur Übertragung wenigstens eines Restes R auf eine Verbindung gemäß der allgemeinen Formel E(X)_{q} zur Herstellung einer Verbindung gemäß der allgemeinen Formel E(X)_{q-p}Rₚ (II) unter Verwendung einer Verbindung des Typs Li[AlR₄] (I) die Nachteile des Standes der Technik überwunden. Das beanspruchte Verfahren ist aus (atom)ökonomischer und ökologischer als befriedigend zu bewerten.

Außerdem wird die Aufgabe gelöst durch die Verwendung eines Lithiumalkylaluminats gemäß der allgemeinen Formel Li[AlR₄] (I) zur Herstellung von Verbindungen gemäß der allgemeinen Formel (R)EH₂ (III). Insbesondere liegt das zu verwendende Lithiumalkylaluminat gemäß der allgemeinen Formel Li[AlR₄] (I) als Feststoff oder Flüssigkeit vor, erhalten oder erhältlich nach einem Verfahren zur Herstellung einer Verbindung gemäß der allgemeinen Formel Li[AlR₄] (I) gemäß einem der weiter oben beschriebenen Ausführungsbeispiele. Alternativ wird das zu verwendende Lithiumalkylaluminat gemäß der allgemeinen Formel Li[AlR₄] (I) als Lösung eingesetzt, umfassend ein Lithiumalkylaluminat gemäß der allgemeinen Formel Li[AlR₄] (I) und wenigstens ein aprotisches Lösungsmittel. Die Lösung ist jeweils ebenfalls erhalten oder erhältlich nach einem Verfahren zur Herstellung einer Verbindung gemäß der allgemeinen Formel Li[AlR₄] (I) gemäß einem der weiter oben beschriebenen Ausführungsbeispiele. Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. E ist ausgewählt aus der Gruppe bestehend aus Phosphor, Antimon und Bismuth.

Bei der vorgenannten Verwendung eines Lithiumalkylaluminats gemäß der allgemeinen Formel Li[AlR₄] (I) zur Herstellung von Verbindungen gemäß der allgemeinen Formel (R)EH₂ (III) handelt es sich um ein Verfahren zur Herstellung von Verbindungen gemäß der allgemeinen Formel (R)EH₂ (III) unter Verwendung eines Lithiumalkylaluminats gemäß der allgemeinen Formel Li[AlR₄] (I). Insbesondere liegt das zu verwendende Lithiumalkylaluminat gemäß der allgemeinen Formel Li[AlR₄] (I) als Feststoff oder Flüssigkeit vor, erhalten oder erhältlich nach einem Verfahren zur Herstellung einer Verbindung gemäß der allgemeinen Formel Li[AlR₄] (I) gemäß einem der weiter oben beschriebenen Ausführungsbeispiele. Alternativ wird das zu verwendende Lithiumalkylaluminat gemäß der allgemeinen Formel Li[AlR₄] (I) als Lösung eingesetzt, umfassend ein Lithiumalkylaluminat gemäß der allgemeinen Formel Li[AlR₄] (I) und wenigstens ein aprotisches Lösungsmittel. Die Lösung ist jeweils ebenfalls erhalten oder erhältlich nach einem Verfahren zur Herstellung einer Verbindung gemäß der allgemeinen Formel Li[AlR₄] (I) gemäß einem der weiter oben beschriebenen Ausführungsbeispiele. Dabei ist R ausgewählt aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. R^{A} ist ausgewählt aus der Gruppe bestehend aus einem Alkylenrest (C1 - C6) und einem teilweise oder vollständig halogenierten Alkylenrest (C1 - C6). Die Reste R^{B} sind unabhängig voneinander ausgewählt aus der Gruppe bestehend aus einem Alkylrest (C1 - C10), einem teilweise oder vollständig halogenierten Alkylrest (C1 - C10) und einem Alkyletherrest O-R^{E}. Dabei sind die Reste R^{E} unabhängig voneinander ausgewählt aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren. Das Verfahren umfasst die Schritte:
a) Zurverfügungstellung einer Lösung des Lithiumalkylaluminats gemäß der allgemeinen Formel Li[AlR₄] (I) in wenigstens einem aprotischen Lösungsmittel,
b) Umsetzung der Lösung aus Schritt a) mit einer Verbindung EX₃ in einem Reaktionsbehältnis, wobei
   - E ausgewählt ist aus der Gruppe bestehend aus Phosphor, Antimon und Bismuth
      und
   - X = Halogen, insbesondere X = F, Cl oder Br,
      und
c) Hinzufügen einer Lösung oder einer Suspension umfassend ein hydridisches Reduktionsmittel in einem aprotischen Lösungsmittel Sz,
   wobei
   - ein molares Verhältnis EX₃ : Li[AlR₄] (I) ≥ 4 ist
      und
   - ein molares Verhältnis EX₃ : hydridisches Reduktionsmittel ≤ 1 ist.

Die Verbindungen EX₃, welche für die Verwendung eines Lithiumalkylaluminats gemäß der allgemeinen Formel Li[AlR₄] (I) zur Herstellung von Verbindungen gemäß der allgemeinen Formel (R)EH₂ (III) beziehungsweise für das Verfahren zur Herstellung von Verbindungen gemäß der allgemeinen Formel (R)EH₂ (III) unter Verwendung eines Lithiumalkylaluminats gemäß der allgemeinen Formel Li[AlR₄] (I) zu verwenden sind, sind kommerziell erhältlich.

Mit der hier beanspruchten Verwendung beziehungsweise dem beanspruchten Verfahren ist beispielsweise *t*BuPH₂ (TBP) auf besonders einfache Weise selektiv und in guter Ausbeute und hoher Reinheit erhältlich.

In einer Ausführungsform der beanspruchten Verwendung beziehungsweise des beanspruchten Verfahrens umfasst die Umsetzung gemäß Schritt b) das Hinzufügen der Verbindung EX₃ als Lösung in einem aprotischen Lösungsmittel S_{F} oder als Feststoff zu der Lösung des Lithiumalkylaluminats gemäß der allgemeinen Formel Li[AlR₄] (I) in dem wenigstens einen aprotischen Lösungsmittel. In Schritt c) erfolgt das Hinzufügen einer Lösung oder einer Suspension des hydridischen Reduktionsmittels in dem aprotischen Lösungsmittel Sz zu der Reaktionsmischung aus Schritt b). Das Hinzufügen der Lösung in Schritt b) und der Lösung oder der Suspension in Schritt c) kann beispielsweise durch Zutropfen oder Zuspritzen erfolgen. Wird die Verbindung EX₃ in Schritt b) als Feststoff hinzugefügt, so wird für die Zugabe beispielsweise ein Trichter oder eine trichterähnliche Vorrichtung verwendet.

In einer weiteren Ausführungsform der beanspruchten Verwendung beziehungsweise des beanspruchten Verfahrens sind das Lösungsmittel S_{F}, das wenigstens eine aprotische Lösungsmittel und das Lösungsmittel S_{Z} unabhängig voneinander ausgewählt aus der Gruppe bestehend aus Kohlenwasserstoffen, Benzol und Benzolderivaten. Beispielsweise sind das Lösungsmittel S_{F}, das wenigstens eine aprotische Lösungsmittel und das Lösungsmittel S_{Z} unabhängig voneinander ausgewählt aus der Gruppe bestehend aus *n*-Pentan, *n-*Hexan, *n*-Heptan, *n*-Octan, *n*-Nonan, *n*-Decan, *n*-Undecan, *n*-Dodecan, Cyclopentan, Cyclohexan, Cycloheptan, 1-Penten, 1-Hexen, 1-Hepten, 1-Octen, 1-Nonen, 1-Decen, 1-Undecen, 1-Dodecen, Cyclohexen, Benzol, Toluol und Xylol sowie deren Isomeren. Auch der Einsatz von Gemischen zweier oder mehrerer Lösungsmittel ist jeweils möglich, insbesondere von Gemischen aliphatischer Kohlenwasserstoffe. Bevorzugt sind *n*-Pentan, *n*-Hexan, *i*-Hexan und *n*-Decan sowie mögliche Gemische.

Eine weitere Ausführungsform der beanspruchten Verwendung beziehungsweise des beanspruchten Verfahrens sieht vor, dass das Lösungsmittel S_{F}, das wenigstens eine aprotische Lösungsmittel und das Lösungsmittel S_{Z} mischbar oder identisch sind.

Ein molares Verhältnis E(X)₂R : hydridisches Reduktionsmittel wird so gewählt, dass die zwei Halogenidanionen X⁻ durch zwei Hydridionen H⁻ ersetzt werden. Bevorzugt ist das molare Verhältnis E(X)₂R : hydridisches Reduktionsmittel ≤ 1.

In einer Ausführungsform der Verwendung eines Lithiumalkylaluminats gemäß der allgemeinen Formel Li[AlR₄] (I) zur Herstellung von Verbindungen gemäß der allgemeinen Formel (R)EH₂ (III) beziehungsweise des Verfahrens zur Herstellung von Verbindungen gemäß der allgemeinen Formel (R)EH₂ (III) unter Verwendung eines Lithiumalkylaluminats gemäß der allgemeinen Formel Li[AlR₄] (I) wird das hydridische Reduktionsmittel *in situ* hergestellt durch eine Reaktion von NaAlH₄ mit einem Glycolether. Dabei beträgt ein molares Verhältnis NaAlH₄ : Glycolether 1 : 2, also 0,5.

Die Definition des Ausdrucks *"in situ* hergestellt" im Zusammenhang mit der vorliegenden Erfindung ist bereits weiter oben gegeben.

In einer weiteren Ausführungsform der Verwendung eines Lithiumalkylaluminats gemäß der allgemeinen Formel Li[AlR₄] (I) zur Herstellung von Verbindungen gemäß der allgemeinen Formel (R)EH₂ (III) beziehungsweise des Verfahrens zur Herstellung von Verbindungen gemäß der allgemeinen Formel (R)EH₂ (III) unter Verwendung eines Lithiumalkylaluminats gemäß der allgemeinen Formel Li[AlR₄] (I) ist der Glycolether ausgewählt aus der Gruppe bestehend aus einem Monoethylenglycolmonoether, einem Diethylenglycolmonoether, einem Triethylengylcolmonoether, einem Monopropylenglycolmonoether, einem Dipropylenglycolmonoether und einem Tripropylenglycolmonoether. Bevorzugt eingesetzt wird ein Monoethylenglycolmonoether oder ein Diethylenglycolmonoether, besonders bevorzugt Ethylenglycolbutylether oder Diethylenglykolmonobutylether. Vorteilhaft bei einem Diethylenglycolmonoether, insbesondere solchen, bei denen die endständige Alkylgruppe wenigstens vier Kohlenstoffatome umfasst, ist deren vergleichsweise bessere Löslichkeit in aliphatischen Kohlenwasserstoffen. Letztere kommen bei dem hier beanspruchten Verfahren bevorzugt als Lösungsmittel zum Einsatz, insbesondere *n*-Pentan, *n*-Hexan, *n-*Heptan, *n*-Octan, *n*-Nonan, *n*-Decan, *n*-Undecan und *n*-Dodecan sowie deren Isomere. Zudem finden Cyclopentan, Cyclohexan, Cycloheptan, 1-Penten, 1-Hexen, 1-Hepten, 1-Octen, 1-Nonen, 1-Decen, 1-Undecen, 1-Dodecen, Cyclohexen, Benzol, Toluol und Xylol, sowie deren Isomere.

In einer anderen Variante des Verfahrens zur Herstellung einer Verbindung gemäß der allgemeinen Formel (R)EH₂ (III) ist das hydridische Reduktionsmittel Natrium-bis(2-methoxy-ethoxy)-aluminium-dihydrid oder Lithiumaluminiumhydrid. Mithin handelt es sich um ein kommerziell erhältliches hydridisches Reduktionsmittel. Natrium-bis(2-methoxy-ethoxy)-aluminium-dihydrid ist ein Dihydrido-dialkoxy-aluminat und auch bekannt als Synhydrid, Red-Al® und Vitrid®. Dieses Reduktionsmittel ist in Form einer viskosen, toluolischen Lösung kommerziell erhältlich, wobei ein ungefährer Gewichtsanteil von > 60w% angegeben wird.

In einer noch anderen Variante der Verwendung eines Lithiumalkylaluminats gemäß der allgemeinen Formel Li[AlR₄] (I) zur Herstellung von Verbindungen gemäß der allgemeinen Formel (R)EH₂ (III) beziehungsweise für das Verfahren zur Herstellung von Verbindungen gemäß der allgemeinen Formel (R)EH₂ (III) unter Verwendung eines Lithiumalkylaluminats gemäß der allgemeinen Formel Li[AlR₄] (I) wird die Lösung, umfassend ein Lithiumalkylaluminat gemäß der allgemeinen Formel Li[AlR₄] (I) und wenigstens ein aprotisches Lösungsmittel, *in situ* hergestellt. Das bedeutet, dass LiAlH₄ mit RLi in einem molaren Verhältnis von 1 : 4, d. h. 0,25, in einem aprotischen Lösungsmittel umgesetzt werden. Die nach der Umsetzung vorliegende Reaktionsmischung, umfassend ein Lithiumalkylaluminat gemäß der allgemeinen Formel Li[AlR₄] (I), kann unmittelbar, d. h. ohne irgendeinen vorgeschalteten Aufreinigungsschritt, der Umsetzung mit EX₃ unterworfen werden. Vor der Zugabe des hydridischen Reduktionsmittels werden die im Reaktionsgemisch enthaltenen Nebenprodukte, in der Regel LiH und LiAIX, durch eine Filtration abgetrennt. Das Filtrat wird zwischenzeitlich in einem weiteren Reaktionsgefäß aufgefangen und kann danach wieder in das ursprüngliche Reaktionsbehältnis zurückgeführt werden, z. B. mittels eines Pumpvorgangs. Mithin kann die beanspruchte Verwendung beziehungsweise das beanspruchte Verfahren auch als Eintopfsynthese durchgeführt werden.

Die Aufgabe wird außerdem gelöst durch Verbindungen gemäß der allgemeinen Formel (R)EH₂ (III), erhältlich nach einem Verfahren zur Herstellung von Verbindungen gemäß der allgemeinen Formel (R)EH₂ (III) unter Verwendung eines Lithiumalkylaluminats gemäß der allgemeinen Formel Li[AlR₄] (I), gemäß einem der weiter oben beschriebenen Ausführungsbeispiele. Mit gemäß einer Ausführungsform des weiter oben beschriebenen Verfahrens erhältlichen Verbindungen gemäß der allgemeinen Formel (R)EH₂ (III) zeichnen sich insbesondere durch eine hohe Reinheit aus. Beispielsweise ist *t*BuPH₂ (TBP) auf besonders einfache Weise selektiv und in hoher Reinheit erhältlich.

Mit dem beanspruchten Verfahren sind definierte Lithiumalkylaluminate gemäß der allgemeinen Formel Li[AlR₄] (I) auf einfache, kostengünstige und reproduzierbare Art und Weise in hoher Reinheit und guten Ausbeuten darstellbar. Besonders vorteilhaft ist, dass kommerziell erhältliches LiAlH₄ und RLi als Edukte dienen. Außerdem wird vorteilhafterweise auf koordinierende Lösungsmittel, insbesondere Ether, verzichtet. Die Verbindungen gemäß der allgemeinen Formel Li[AlR₄] (I) sind in diversen nicht-etherischen organischen Lösungsmitteln herstellbar und zeigen eine gute Löslichkeit in ihnen, insbesondere in unpolaren Lösungsmitteln. Es bedarf keiner aufwändigen Reinigung des jeweils isolierten Produkts durch fraktionierende Destillation und/oder Sublimation. Die Verbindungen des Typs Li[AlR₄] (I) können zur Herstellung definierter Stammlösungen in unpolaren Solventien verwendet und als solche für eine später Verwendung gelagert werden. Die Verbindungen gemäß der allgemeinen Formel Li[AlR₄] zeichnen sich zudem dadurch aus, dass sie - auch in Form ihrer Stammlösungen - eine selektive Übertragung einer oder mehrerer Alkylreste R auf eine Vielzahl von Metall- und Elementhalogeniden ermöglichen. Dabei fallen - unter den ansonsten gewählten Reaktionsbedingungen - ausschließlich vergleichsweise einfach abzutrennende Nebenprodukte an, nämlich in der Regel LiAlX₄, in Einzelfällen LiX. Weiterhin vorteilhaft ist, dass im Falle der Übertragung von vier Resten R ausgehend von einem Moläquivalent Li[AlR₄] (I) die anfallende Salzfracht - im Vergleich zum Einsatz eines Alkylierungsreagenzes, durch welches pro Moläquivalent lediglich ein Rest R übertragbar ist - deutlich verringert ist. Die Alkylierungsprodukte zeichnen sich wiederum durch eine hohe Reinheit aus. Insgesamt ist das beanspruchte Verfahren unter ökologischen und ökonomischen Aspekten als zufriedenstellend zu bewerten.

Weitere Merkmale, Einzelheiten und Vorteile der Erfindung ergeben sich aus dem Wortlaut der Ansprüche sowie aus der folgenden Beschreibung von Ausführungsbeispielen anhand der Figuren. Es zeigen:
- **Fig. 1**: ²⁷Al-gekoppeltes ¹H-NMR-Spektrum von Li[Al*t*Bu₄], hergestellt gemäß Ausführungsbeispiel 1, nach einfacher Umkondensation,
- **Fig. 2**: ¹H-gekoppeltes ²⁷Al-NMR-Spektrum von Li[Al*t*Bu₄], hergestellt gemäß Ausführungsbeispiel 1, nach einfacher Umkondensation,
- **Fig. 3**: ²⁷Al-gekoppeltes ¹³C-NMR-Spektrum von Li[Al*t*Bu₄], hergestellt gemäß Vergleichsbeispiel 1, nach einfacher Umkondensation,
- **Fig. 4**: ¹H-entkoppelten ²⁷Al-NMR-Spektrum von Li[Al*t*Bu₄], hergestellt gemäß Ausführungsbeispiel 1, nach einfacher Umkondensation,
- **Fig. 5**: ²⁷Al-gekoppelten ¹H-NMR-Spektrum von Li[Al(CH₂SiMe₃)₄], hergestellt gemäß Ausführungsbeispiel 2, nach einfacher Umkondensation,
- **Fig. 6**: ¹H-gekoppeltens ²⁷Al-NMR-Spektrum von Li[Al(CH₂SiMe₃)₄], hergestellt gemäß Ausführungsbeispiel 2, nach einfacher Umkondensation,
und
- **Fig. 7**: ¹H-gekoppeltes ³¹P-NMR-Spektrum von *t*BuPH₂, hergestellt in einer Eintopfsynthese gemäß Ausführungsbeispiel 4, nach fraktionierter Destillation.

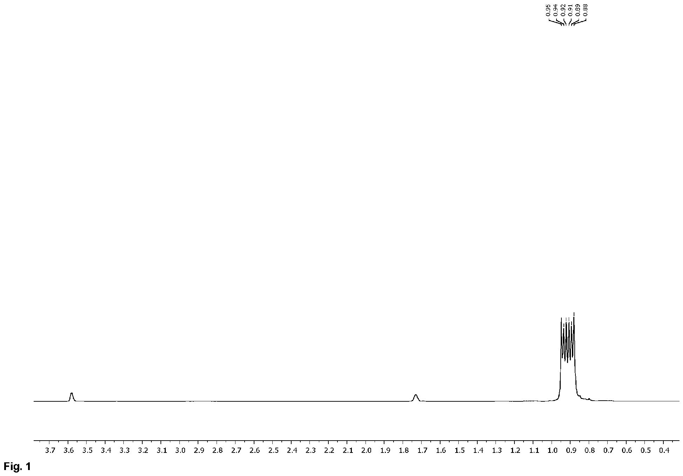

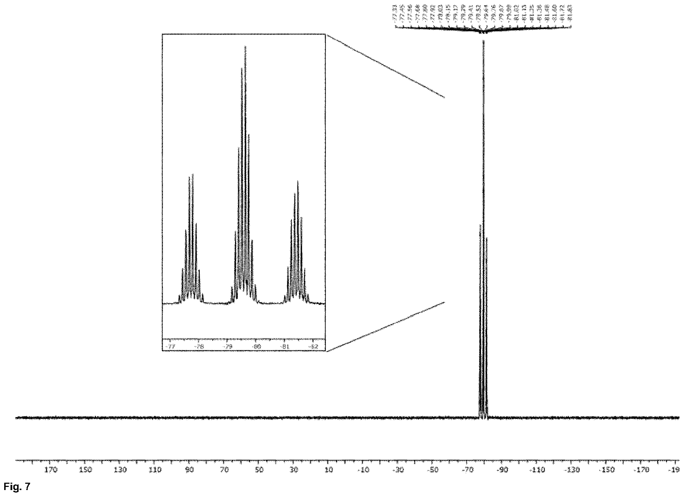

Die in **Fig. 1** bis **Fig. 6** gezeigten NMR-Spektren wurden in THF-_{*d*8} aufgenommen. Für die Messung des in **Fig. 7** abgebildeten NMR-Spektrums wurde n-Decan als Lösungsmittel verwendet. Auf der x-Achse ist jeweils die chemische Verschiebung *δ* in ppm aufgetragen. Die jeweiligen Temperaturen (in K) und Frequenzen (in MHz), bei welchen die einzelnen NMR-Spektren aufgenommen wurden, können den Arbeitsvorschriften, genauer gesagt den jeweiligen Auswertungen der in **Fig. 1** bis **Fig. 7** dargestellten NMR-Spektren, entnommen werden.

**Fig. 1** zeigt ein ²⁷Al-gekoppeltes ¹H-NMR-Spektrum von Li[Al*t*Bu₄], hergestellt gemäß einer Ausführungsform des beanspruchten Verfahrens (vgl. Ausführungsbeispiel 1). Isoliert wurde das Produkt Li[Al*t*Bu₄] durch eine einfache Kondensation des Lösungsmittels n-Pentan im Feinvakuum (10⁻² bis 10⁻³ mbar). Wie in **Fig. 1** zu sehen ist, wird lediglich ein Signal bei einer chemischen Verschiebung *δ*_{H} von 0,91 ppm beobachtet. Eine Aufspaltung des Signals zu einem Sextett mit einer Kopplungskonstante ³*J*_{HAl} = 4 Hz ist auf die Kemspinquantenzahl des koppelnden Aluminiumkerns zurückzuführen. Die Tatsache, dass in dem in **Fig. 1** dargestellten ²⁷Al-gekoppelten ¹H-NMR-Spektrum nur ein Signal zu beobachten ist, lässt auf eine vollständige und selektive Umsetzung zum gewünschten Zielprodukt Li[Al*t*Bu₄] schließen.

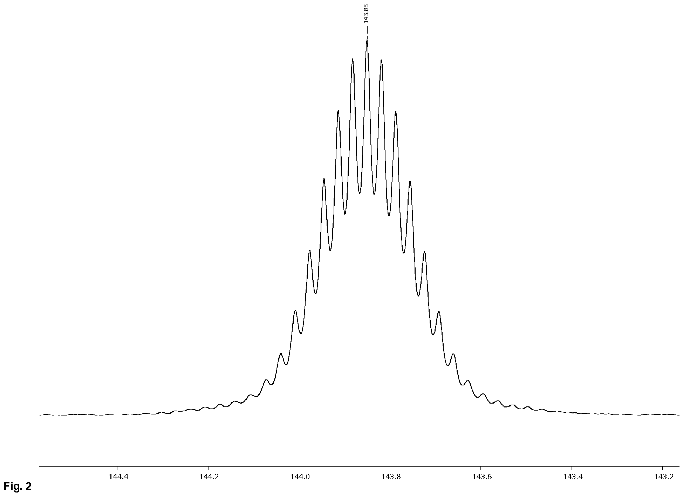

In **Fig. 2** ist ein ¹H-gekoppeltes ²⁷Al-NMR-Spektrum von Li[Al*t*Bu₄] gezeigt. Das einzige Signal bei einer chemischen Verschiebung von *δ*_{Al} = 143,9 ppm erscheint aufgrund der Kopplung zu 36 Wasserstoffatomen als Multiplett, welches - in Übereinstimmung mit dem ²⁷Al-gekoppelten ¹H-NMR-Spektrum von Li[Al*t*Bu₄] (vgl. **Fig. 1**) - eine Kopplungskonstante ³*J*_{AlH} = 4 Hz aufweist.

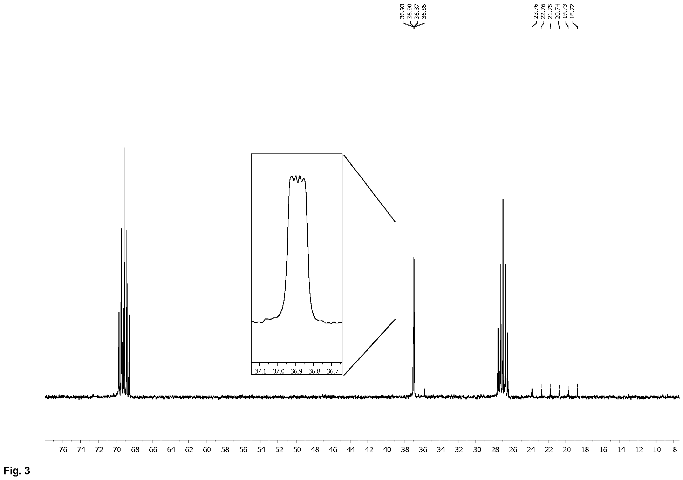

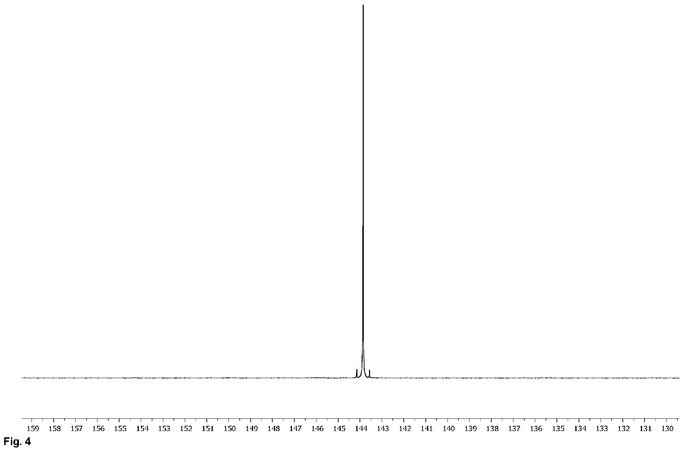

**Fig. 3** zeigt ein ²⁷Al-gekoppeltes ¹³C-NMR-Spektrum von Li[Al*t*Bu₄] mit einem Sextett als einzigem Signal bei einer chemischen Verschiebung *δ*_{C} = 19,5 ppm. Eine Kopplungskonstante ¹*J*_{CAl} beträgt 76 Hz. Derselbe Wert wurde über Satelliten in einem ¹H-entkoppelten ²⁷Al-NMR-Spektrum von Li[Al*t*Bu₄] ermittelt (vgl. **Fig. 4**).

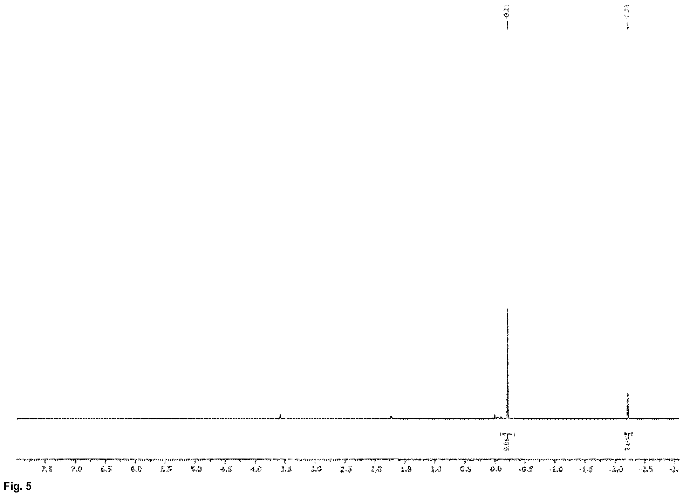

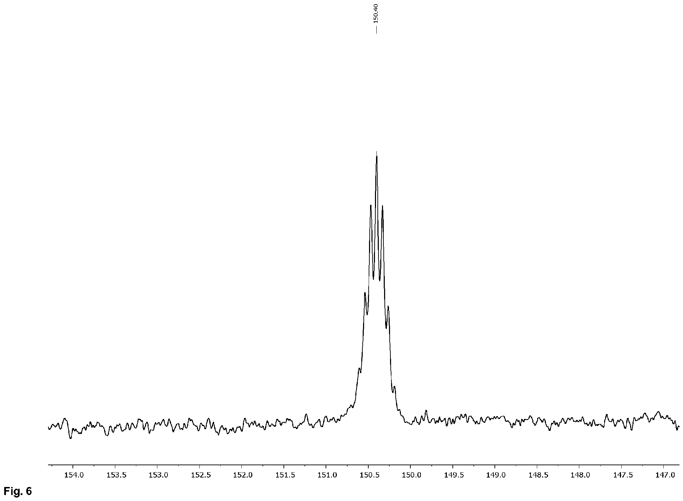

In **Fig. 5** ist ein ²⁷Al-gekoppeltes ¹H-NMR-Spektrum von Li[Al(CH₂SiMe₃)₄] gezeigt. Es sind zwei Singuletts für einen CH₂SiMe₃-Rest zu beobachten, wobei die CH₂-Einheit bei einer chemischen Verschiebung von *δ*_{H} = -2,22 ppm und die SiMe₃-Gruppe bei einer chemischen Verschiebung *δ*_{H} = 0,21 ppm detektiert wird. Ein ¹H-gekoppeltes ²⁷Al-NMR-Spektrum von Li[Al(CH₂SiMe₃)₄] (**Fig. 6**) zeigt lediglich ein Signal bei einer chemischen Verschiebung von *δ*_{Al} = 150,4 ppm. Dies lässt auf eine vollständige und selektive Umsetzung zum gewünschten Produkt Li[Al(CH₂SiMe₃)₄] schließen. Das im ¹H-gekoppeltes ²⁷Al-NMR-Spektrum (**Fig. 6**) beobachtete Signal ist im Vergleich zu dem entsprechenden Signal von Li[Al*t*Bu₄] (vlg. **Fig. 2**) tieffeldverschoben. Dies lässt sich durch eine vergleichsweise geringere Elektronendichte am Aluminium aufgrund des weniger starken +I-Effekts des CH₂SiMe₃-Restes erklären. Anhand des ¹H-gekoppelten ²⁷Al-NMR-Spektrums (**Fig. 6**) wurde eine Kopplungskonstante ²*J*_{AlH} = 9,1 Hz ermittelt.

**Fig.** 7 zeigt ein ¹H-gekoppeltes ³¹P-NMR-Spektrum von *t*BuPH₂ (TBP) hergestellt in einer Eintopfsynthese gemäß Ausführungsbeispiel 4, umfassend eine Isolierung durch eine fraktionierte Destillation. Anhand des ³¹NMR-Spektrums ist zu erkennen, dass die Herstellung des gewünschten Produktes *t*BuPH₂ selektiv erfolgte. Das eingesetzte Lösungsmittel n-Decan und die Zielverbindung *t*BuPH₂ weisen signifikant unterschiedliche Siedepunkte auf. Mithin wurden die beiden Verbindungen mittels fraktionierter Destillation vollständig voneinander getrennt.

### Arbeitsvorschriften zur Synthese von Li[AltBu₄], Li[Al(CH₂SiMe₃)₄], PCl₂tBu, tBuPH₂, PCltBu₂, PtBu₃, ZntBu₂, AltBu₃ und Al(CH₂SiMe₃)₃

### Materialien und Methoden:

Alle Reaktionen wurden unter Schutzgasatmosphäre durchgeführt. Dabei wurde mit Hilfe gängiger Schlenk-Techniken gearbeitet, wobei Stickstoff oder Argon als Schutzgas eingesetzt wurden. Die entsprechenden Vakuum-Rechen bzw. Schlenk-Linien waren mit Drehschieberpumpen der Fa. Vacuubrand verbunden. Das Abwiegen und Lagern von Edukten, Reagenzien und synthetisierten Produkten erfolgte in Handschuhkästen der Fa. MBraun (Typ MB 150 *BG-1* oder *Lab Master 130*) unter Stickstoffatmosphäre.

Die eingesetzten Lösungsmittel wurden nach Standardprozeduren getrocknet und in Edelstahlsäulen über geeigneten Trocknungsmitteln (Molsieb, Aluminiumoxid, Kupferkatalysator) gelagert. Die Lösungsmittel CDCl₃ und CD₂Cl₂ wurden über Molsieb 3 Å absolutiert, kondensiert und dann über Molsieb 3 Å gelagert. Bei Gaseinleitungen von NH₃ wurde dieses zuvor durch ein Trockenrohr mit KOH-Plätzchen geleitet.

Alle kemresonanzspektroskopischen Messungen wurden in Automation an einem Gerät des Typs AV II 300 oder im Handbetrieb an einem Gerät des Typs AV III HD 250, AV III HD 300 oder AV III 500 durchgeführt. Die Heterokern-NMR-Spektren ⁷Li, ¹³C, ²⁷Al, ²⁹Si, ³¹P wurden standardmäßig ¹H-breitbandentkoppelt bei 300 K gemessen. Falls ²⁷Al- oder ³¹P-NMR-Spektren sowohl ¹H-entkoppelt und -gekoppelt gemessen wurden, erfolgt die direkte Unterscheidung derart, dass ersteres mit ²⁷Al{¹H}/³¹P{¹H} und zweites ²⁷Al/³¹P gekennzeichnet wird. ¹H- und ¹³C-NMR-Spektren wurden auf das entsprechende Restprotonensignal des Lösungsmittels als interner Standard kalibriert: ¹H: C₆D₆: 7,16 ppm (s), THF-*d₈*: 1,72 ppm (brs). ¹³C: C₆D₆: 128,0 ppm (t), THF-*d₈*: 25,2 ppm (quin). Die chemischen Verschiebungen werden in ppm angegeben und beziehen sich auf die δ-Skala. Alle Signale werden entsprechend ihres Aufspaltungsmusters mit den folgenden Abkürzungen versehen: s (Singulett), quint (Quintett), sext (Sextett) oder sept (Septett); br (breit). Die Kopplung zwischen zwei Kernen A und B über n Bindungen werden durch die Kopplungskonstante der Form ⁿ*J*_{AB} in Hertz (Hz) angegeben.

Die Messungen von Infrarotspektren erfolgten in Substanz in der Regel an einem Alpha ATR-IR-Spektrometer der Fa. Bruker. Die Absorptionsbanden sind angegeben in Wellenzahl (cm⁻¹) und die Intensität wird mit folgenden Abkürzungen beschrieben: w (schwach), m (mittelstark), st (stark), vst (sehr stark), br (breit). Normiert wurden die Spektren stets auf die intensitätsstärkste Bande.

Die Elementaranalysen wurden an einem Vario-Micro-Cube Verbrennungsgerät der Fa. Elementar durchgeführt. Die Probenvorbereitung erfolgte in einem mit Stickstoff gefluteten Handschuhkasten durch Einwiegen der Substanz in Zinn-Tiegel, welche kalt verschweißt und bis zur Messung unter Schutzgasatmosphäre gelagert wurden. Die Elemente Wasserstoff, Kohlenstoff und Stickstoff wurden über eine Verbrennungsanalyse ermittelt, wobei die Angabe stets in Massenprozent erfolgt.

Die thermogravimetrischen Untersuchungen wurden an einem TGA/DSC 3+ STAR System der Fa. Mettler Toledo durchgeführt. Dabei wurde bei jeder TGA- eine gekoppelte SDTA-Messung durchgeführt. Die Proben wurden je nach Methode bzw. je nach Aggregatzustand in Aluminiumoxid-, Aluminium- oder Saphirtiegeln gemessen. Die Probe wurde mit einer bestimmten Heizrate von 25 °C bis zur Endtemperatur erhitzt. Die Auswertung der erhaltenen Spektren erfolgte mit STARe Software der Fa. Mettler Toledo.

### Ausführungsbeispiel 1: Darstellung von Li[AltBu₄] in n-Pentan

LiAlH₄ (150 mg, 3,95 mmol, 1,00 eq) wurde in 10 mL n-Pentan vorgelegt und tropfenweise mit einer Lösung von *t*BuLi in *n*-Hexan (8,64 mL, 1,83 M, 15,8 mmol, 4,00 eq) versetzt. Dabei wurde beobachtet, dass das eingesetzte LiAlH₄ in Lösung ging, während ein farbloser Feststoff ausfiel. Die farblose Suspension wurde für 16 h bei Raumtemperatur gerührt. Das emulsionsartige Reaktionsgemisch wurde filtriert, der Filterkuchen mit 5 mL n-Pentan gewaschen und das Lösungsmittel des Filtrats im Feinvakuum (10⁻² bis 10⁻³ mbar) entfernt. Das gewünschte Produkt wurde als farbloser Feststoff erhalten. Die Ausbeute betrug 80% (824 mg, 3,14 mmol).

Alternativ wurde das Produkt durch Dekantieren und anschließendes Trocknen isoliert. Als alternative Lösungsmittel wurden beispielsweise *n*-Hexan und *n*-Decan verwendet.

**¹H-NMR** (C₆D₆, 300 MHz, 300 K): δ/ppm = 1,10 (s, C*Me₃*); **¹H-NMR** (THF-*d*₈, 500 MHz, 300 K): δ/ppm = 0,91 (sext, ³*J*_{HAl} = 4 Hz, C*Me₃*); **¹H{²⁷Al)-NMR** (THF-*d*₈, 500 MHz, 300 K): *δ*/ppm = 0,91 (s, C*Me₃*); **¹³C-NMR** (C₆D₆, 75 MHz, 300 K): δ/ppm = 33,3 (s, C*Me*₃); **¹³C-NMR** (THF-*d*₈, 75 MHz, 300 K): *δ*/ppm = 19,5 (sext, ¹*J*_{CAl} = 76 Hz, CMe₃), 35,1 (brs, *CMe*₃); **⁷Li-NMR** (THF-*d*₈, 117 MHz, 300 K): *δ*/ppm = -0,48 (s); **²⁷Al-NMR** (THF-*d*₈, 130 MHz, 300 K): δ/ppm = 143,9 (m, ³*J*_{AlH} = 4 Hz); **²⁷Al{¹H)-NMR** (THF-*d*₈, 130 MHz, 300 K): δ/ppm = 143,9 (s); **IR:** *ṽ*/cm⁻¹ = 2955 (m), 2933 (m), 2864 (m), 2814 (vst), 1496 (w), 1467 (m), 1382 (m), 1259 (w), 1170 (w), 1005 (w), 916 (m), 805 (st), 784 (vstbr), 557 (w), 523 (st), 439 (st).

### Ausführungsbeispiel 2: Darstellung von Li[Al(CH₂SiMe₃)₄] in n-Pentan

LiAlH₄ (100 mg, 2,64 mmol, 1,00 eq) wurde in 10 mL *n*-Pentan suspendiert und auf 0 °C gekühlt. Bei Raumtemperatur wurde eine Lösung von LiCH₂SiMe₃ (992 mg, 10,5 mmol, 4,00 eq) in 15 mL *n*-Pentan zugetropft. Das farblose Reaktionsgemisch wurde für 1 h bei 0 °C, anschließend für 48 h bei Raumtemperatur gerührt. Der ausgefallene, farblose Feststoff wurde filtriert und das Lösungsmittel des Filtrats im Feinvakuum (10⁻² bis 10⁻³ mbar) entfernt. Das Produkt wurde mit einer Ausbeute von 39% (399 mg, 1,04 mmol) in Form eines farblosen Feststoffs erhalten.

Die Ausbeute kann durch wiederholtes Extrahieren des Filterkuchens gesteigert werden.

**¹H-NMR** (C₆D₆, 300 MHz, 300 K): *δ*/ppm = -2,04 (s, 8 H, C*H*₂SiMe₃), 0,18 (s, 36 H, CH₂Si*Me₃*); **¹H-NMR** (THF-*d₈*, 300 MHz, 300 K): *δ*/ppm = -2,22 (s, 8 H, C*H₂*SiMe₃), 0,21 (s, 36 H, CH₂Si*Me*₃); **¹³C-NMR** (C₆D₆, 75 MHz, 300 K): *δ*/ppm = -4,6 (s, *C*H₂SiMe₃), 3,6 (s, CH₂Si*Me*₃); **¹³C-NMR** (THF-*d₈*, 75 MHz, 300 K): *δ*/ppm = -7,0 (s, *C*H₂SiMe₃), 6,0 (s, CH₂Si*Me*₃); **⁷Li-NMR** (C₆D₆, 117 MHz, 300 K): *δ*/ppm = 1,3 (s); **⁷Li-NMR** (THF-*d₈*, 117 MHz, 300 K): δ/ppm = 1,3 (s); **²⁷Al-NMR** (C₆D₆, 130 MHz, 300 K): *δ*/ppm = 150,7 (quint, ²*J*_{AlH} = 9,0 Hz); **²⁷Al-NMR** (THF-*d₈*, 130 MHz, 300 K): δ/ppm = 150,4 (sept, ²*J*_{AlH} = 9,1 Hz); ***²⁷*Al{¹H}-NMR** (C₆D₆, 130 MHz, 300 K): *δ*/ppm = 150,6 (s); **²⁷Al{¹H}-NMR** (THF-*d₈*, 130 MHz, 300 K): δ/ppm = 150,4 (s); **²⁹Si{¹H}-NMR** (THF-*d₈*, 99 MHz, 300 K): *δ*/ppm = -3,9 (s); **IR:** *ṽ*/cm⁻¹ = 2945 (m), 2890 (w), 2815 (w), 2787 (w), 1430 (w), 1241 (st), 1046 (w), 935 (w), 851 (vst), 811 (vst), 714 (vst), 668 (st), 603 (w), 454 (st); **Elementaranalyse:** für C₁₆H₄₄AlLiSi₄: berechnet: C: 50,20%, H: 11,59%, N: 0,00%, gefunden: C: 49,53%, H: 10,93%, N: 0,25%. Der ermittelte Stickstoffgehalt der Probe lässt sich durch die Probenvorbereitung in einem mit Stickstoff gefluteten Handschuhkasten begründen.

### Ausführungsbeispiel 3: Übertragung einer tert-Butylgruppe auf PCl₃ in n-Pentan unter Verwendung von Li[AltBu₄] als Transferreagenz

PCl₃ (746 mg, 5,43 mmol, 4,00 eq) wurde in 15 mL *n*-Pentan vorgelegt und auf 0 °C gekühlt. Eine Lösung von Li[Al*t*Bu₄] (356 mg, 1,36 mmol, 1,00 eq) in 20 mL *n*-Pentan wurde tropfenweise zugegeben, wobei das Ausfallen eines farblosen Feststoffs beobachtet wurde. Das Reaktionsgemisch wurde für 16 h bei Raumtemperatur gerührt und anschließend mittels ³¹P-NMR-Spektroskopie untersucht.

Die Synthese wurde alternativ beispielsweise in Toluol, *n*-Hexan und n-Decan durchgeführt. Die Destillation von PCl₂*t*Bu aus Toluol lieferte eine Ausbeute von 84%.

**³¹P-NMR** (*n*-Pentan, 101 MHz, 300 K): *δ*/ppm = 197,2.
Die beobachtete chemische Verschiebung stimmt mit der in der Literatur für PCl₂*t*Bu angegebenen überein.
(Y. Liu, B. Ding, D. Liu, Z. Zhang, Y. Liu, W. Zhang, Res. Chem. Intermed. 2017, 43, 4959 - 4966)

### Ausführungsbeispiel 4: Darstellung von tBuPH₂ unter Verwendung einer Lösung von in situ dargestelltem Li[AltBu₄] in n-Decan (Eintopfsynthese)

PCl₃ (1,45 g, 10,6 mmol, 4,00 eq) wurde in 15 mL n-Decan vorgelegt und auf 0 °C gekühlt. Eine Lösung von *in situ* dargestelltem Li[Al*t*Bu₄] ausgehend von LiAlH₄ (100 mg, 2,65 mmol, 1,00 eq) und *t*BuLi (5,8 mL, 1,83 M, 10,6 mmol, 4,00 eq) in 20 mL *n*-Decan wurde langsam zugetropft, wobei ein farbloser Feststoff ausfiel. Das Reaktionsgemisch wurde 1 h bei Raumtemperatur gerührt, auf 0 °C gekühlt und mit *in situ* dargestelltem Na[AlH₂(OC₂H₄OC₂H₄O*n*Bu)₂] ausgehend von NaAlH₄ (570 mg, 10,6 mmol, 4,00 eq) und 2-(2-Butoxyethoxy)ethanol (3,42 g, 21,1 mmol, 8,00 eq) in 10 mL n-Decan versetzt. Das Reaktionsgemisch wurde langsam auf Raumtemperatur erwärmt und 1 h gerührt. Das Produkt wurde zusammen mit n-Decan im Feinvakuum (10⁻² bis 10⁻³ mbar) umkondensiert. Durch fraktionierte Destillation wurde das gewünschte Produkt *t*BuPH₂ mit einer Ausbeute von 89% (850 mg, 9,43 mmol) als farblose Flüssigkeit isoliert.

Die Reaktion kann in analoger Weise in n-Pentan durchgeführt werden, wobei dies jedoch nicht durch fraktionierte Destillation vom Produkt abgetrennt werden kann.

| | |
|---|---|
| Zwischenprodukt: | **³¹P-NMR** (*n*-Decan, 101 MHz, 300 K): *δ*/ppm = 197,2. |
| Endprodukt: | **³¹P-NMR** (*n*-Decan, 101 MHz, 300 K): *δ*/ppm = -80,3. |

### Ausführungsbeispiel 5: Übertragung zweier tert-Butylgruppen auf PCl₃ in n-Hexan unter Verwendung von Li[AltBu₄] als Transferreagenz

Li[Al*t*Bu₄] (75 mg, 0,29 mmol, 2,00 eq) wurde in 8 mL n-Hexan vorgelegt, auf 0 °C gekühlt und mit PCl₃ (80 mg, 0,58 mmol, 4,00 eq) versetzt. Das Reaktionsgemisch wurde auf Raumtemperatur erwärmt und für 16 h gerührt. Die leicht gelbe Suspension wurde über einen Spritzenfilter filtriert und das Filtrat mittels ³¹P-NMR-Spektroskopie untersucht.

**³¹P-NMR** (n-Pentan, 101 MHz, 300 K): *δ*/ppm = 144,9.
Die beobachtete chemische Verschiebung stimmt mit der in der Literatur für PCl*t*Bu₂ angegebenen überein. (F. Eisenträger, A. Göthlich, I. Gruber, H. Heiss, C. A. Kiener, C. Krüger, J. Ulrich Notheis, F. Rominger, G. Scherhag, M. Schultz, B. F. Straub, M. A. O. Volland, P. Hofmann, New J. Chem. 2003, 27, 540 - 550)

### Ausführungsbeispiel 6: Übertragung dreier tert-Butylgruppen auf PCl₃ in Toluol unter Verwendung von Li[AltBu₄] als Transferreagenz

Li[Al*t*Bu₄] (75 mg, 0,29 mmol, 3,00 eq) wurde in 8 mL Toluol vorgelegt und auf 0 °C gekühlt. Tropfenweise wurde PCl₃ (53 mg, 0,39 mmol, 4,00 eq) hinzugegeben. Das Reaktionsgemisch wurde auf Raumtemperatur erwärmt und für 16 h gerührt. Die leicht gelbe Suspension wurde über einen Spritzenfilter filtriert und das Filtrat wurde mittels ³¹P-NMR-Spektroskopie untersucht.

**³¹P-NMR** (Toluol, 101 MHz, 300 K): δ/ppm = 58,0.
Die beobachtete chemische Verschiebung stimmt mit der in der Literatur für P*t*Bu₃ angegebenen überein. (L. Rösch, W. Schmidt-Fritsche, Z. Anorg. Allg. Chem. 1976, 426, 99 - 106)

### Ausführungsbeispiel 7: Übertragung zweier tert-Butylgruppen auf ZnCl₂ in n-Hexan unter Verwendung von Li[AltBu₄] als Transferreagenz

ZnCl₂ (100 mg, 0,73 mmol, 1,00 eq) wurde in 10 mL n-Hexan vorgelegt und auf -40 °C gekühlt. Eine Lösung von Li[Al*t*Bu₄] (96 mg, 0,37 mmol, 0,50 eq) in 10 mL n-Hexan wurde tropfenweise zugegeben. Die gräuliche Suspension wurde für 8 h auf einer Temperatur von -40 °C gehalten und anschließend langsam auf Raumtemperatur erwärmt. Die Suspension wurde filtriert, auf -10 °C gekühlt und vom Lösungsmittel befreit. Zn*t*Bu₂ wurde nach mehrfachem Gefriertrocknen als farbloser Feststoff mit einer Ausbeute von ungefähr 30% (40 mg, 0,22 mmol) erhalten. Der farblose Feststoff kann unter leicht vermindertem Druck bei Raumtemperatur sublimiert oder bei 40 °C umkondensiert werden.

**¹H-NMR** (C₆D₆, 300 MHz, 300 K): *δ*/ppm = 0,85 (s, *CMe*₃).
Weder im ⁷Li-NMR-Spektrum noch im ²⁷Al-NMR-Spektrum wurde ein Signal detektiert. Mithin erfolgte eine vollständige Umsetzung.

### Ausführungsbeispiel 8: Übertragung dreier tert-Butylgruppen auf AlCl₃ in n-Pentan unter Verwendung von Li[AltBu₄] als Transferreagenz

AlCl₃ (70 mg, 0,53 mmol, 1,00 eq) wurde in 10 mL *n*-Pentan vorgelegt, auf -40 °C gekühlt und mit einer Lösung von Li[Al*t*Bu₄] (417 mg, 1,59 mmol, 3,00 eq) in 20 mL *n*-Pentan versetzt. Das Reaktionsgemisch wurde für 3 h bei -40 °C und 16 h bei Raumtemperatur gerührt. Die leicht graue Suspension wurde bei 0 °C filtriert und das Lösungsmittel des Filtrats wurde bei -10 °C entfernt. Das Produkt Al*t*Bu₃ wurde in Form farbloser Kristalle mit einer Ausbeute von 82% (345 mg, 1,74 mmol) erhalten.

**¹H-NMR** (C₆D₆, 300 MHz, 300 K): *δ*/ppm = 1,18 (s, C*Me₃*); **¹³C-NMR** (C₆D₆, 75 MHz, 300 K): *δ*/ppm =
32,0 (C*Me₃*).
Das quartäre Kohlenstoffatom wurde im ¹³C-NMR-Spektrum nicht detektiert.

### Ausführungsbeispiel 9: Übertragung dreier tert-Butylgruppen auf AlCl₃ in n-Pentan unter Verwendung von Li[AltBu₄] als Transferreagenz im größeren Maßstab

AlCl₃ (700 mg, 5,30 mmol, 1,00 eq) wurde in 120 mL *n*-Pentan vorgelegt, auf -40 °C gekühlt und mit einer, auf 0 °C vorgekühlten Lösung von Li[Al*t*Bu₄] (4,17 g, 15,9 mmol, 3,00 eq) in 250 mL *n*-Pentan versetzt. Das Reaktionsgemisch wurde für 10 h bei -40 °C und 16 h bei Raumtemperatur gerührt. Die graue Suspension wurde bei 0 °C filtriert und das Lösungsmittel des Filtrats wurde bei -10 °C entfernt. Das Produkt wurde nach Umkondensation als kristalliner Feststoff mit einer Ausbeute von 76% (3,19 g, 16,1 mmol) erhalten.

### Ausführungsbeispiel 10: Übertragung dreier CH₂SiMe₃-Gruppen auf AlCl₃ in n-Pentan unter Verwendung von Li[Al(CH₂SiMe₃)₄] als Transferreagenz

AlCl₃ (80 mg, 0,61 mmol, 1,00 eq) wurde in 10 mL *n*-Pentan vorgelegt, auf -40 °C gekühlt und mit einer Lösung von Li[Al(CH₂SiMe₃)₄] (701 mg, 1,59 mmol, 3,00 eq) in 10 mL n-Pentan versetzt. Die leicht graue Suspension wurde für 6 h bei -40 °C und für 16 h bei Raumtemperatur gerührt. Nach Filtration wurde das Lösungsmittel des Filtrats bei -10 °C im Feinvakuum (10⁻² bis 10⁻³ mbar) entfernt. Das Produkt wurde im Feinvakuum (10⁻² bis 10⁻³ mbar) bei 55 °C umkondensiert und als farblose Flüssigkeit erhalten. Die Ausbeute betrug 67% (424 mg, 1,47 mmol).
**¹H-NMR** (C₆D₆, 300 MHz, 300 K): *δ*/ppm = -2,00 (s, 6 H, C*H₂*SiMe₃), -0,25 (s, 27 H, CH₂Si*Me₃*).

Man erkennt, dass die Erfindung Lithiumalkylaluminate gemäß der allgemeinen Formel Li[AlR₄] betrifft sowie ein Verfahren zu deren Herstellung, ausgehend von LiAIH₄ und RLi in einem nicht-etherischen Lösungsmittel. Gegenstand der Erfindung sind zudem Verbindungen gemäß der allgemeinen Formel Li[AIR₄], erhältlich nach dem beanspruchten Verfahren, sowie deren Verwendung. Die Erfindung betrifft weiterhin die Verwendung eines Lithiumalkylaluminats gemäß der allgemeinen Formel Li[AlR₄] als Transferreagenz zur Übertragung wenigstens eines Restes R auf ein Element- oder Metallhalogenid sowie ein Verfahren zur Übertragung wenigstens eines Restes R auf eine Verbindung gemäß der allgemeinen Formel E(X)_{q} zur Herstellung einer Verbindung gemäß der allgemeinen Formel E(X)_{q-p}Rₚ. E ist ausgewählt aus der Gruppe bestehend aus Aluminium, Gallium, Indium, Thallium, Germanium, Zinn, Blei, Antimon, Bismut, Zink, Cadmium, Quecksilber und Phosphor, X = Halogen, q = 2, 3 oder 4 und p = 1, 2, 3 oder 4. Zudem betrifft die Erfindung Verbindungen, erhältlich nach einer Ausführungsform eines solchen Verfahrens, deren Verwendung und ein Substrat, welches auf einer Oberfläche eine Aluminium-Schicht oder eine Aluminium enthaltende Schicht aufweist.

Mit dem beanspruchten Verfahren sind definierte Lithiumalkylaluminate gemäß der allgemeinen Formel Li[AlR₄] (I) auf einfache, kostengünstige und reproduzierbare Art und Weise in hoher Reinheit und guten Ausbeuten darstellbar. Das Verfahren ist auch im industriellen Maßstab durchführbar. Vorteilhafterweise wird auf koordinierende Lösungsmittel, insbesondere Ether, verzichtet. Die Verbindungen gemäß der allgemeinen Formel Li[AlR₄] zeichnen sich zudem dadurch aus, dass sie - auch in Form ihrer Stammlösungen - eine selektive Übertragung einer oder mehrerer Alkylreste R auf eine Vielzahl von Metall- und Elementhalogeniden ermöglichen. Dabei fallen - unter den ansonsten gewählten Reaktionsbedingungen - ausschließlich vergleichsweise einfach abzutrennende Nebenprodukte an, nämlich in der Regel LiAlX₄, in Einzelfällen LiX. Weiterhin vorteilhaft ist, dass im Falle der Übertragung von vier Resten R ausgehend von einem Moläquivalent Li[AlR₄] (I) die anfallende Salzfracht - im Vergleich zum Einsatz eines Alkylierungsreagenzes, durch welches pro Moläquivalent lediglich ein Rest R übertragbar ist - deutlich verringert ist. Die Alkylierungsprodukte zeichnen sich wiederum durch eine hohe Reinheit aus und eignen sich daher besonders gut als Präkursoren für Gasphasenabscheidungsverfahren. Die mit dem beanspruchten Verfahren darstellbaren Verbindungen AlR₃ sind als Präkursoren zur Herstellung qualitativ hochwertiger Aluminium-Schichten oder Aluminium enthaltender Schichten geeignet.

Sämtliche aus den Ansprüchen, der Beschreibung und den Figuren hervorgehenden Merkmale und Vorteile, einschließlich konstruktiver Einzelheiten, räumlicher Anordnungen und Verfahrensschritten, können sowohl für sich als auch in den verschiedensten Kombinationen erfindungswesentlich sein.

## Patentansprüche

1. Lithiumalkylaluminate gemäß der allgemeinen Formel
Li[AlR₄] (I),
wobei
die Reste R unabhängig voneinander ausgewählt sind aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
wobei
- R^{A} ausgewählt ist aus der Gruppe bestehend aus einem Alkylenrest (C1 - C6) und einem teilweise oder vollständig halogenierten Alkylenrest (C1 - C6),
- die Reste R^{B} unabhängig voneinander ausgewählt sind aus der Gruppe bestehend aus einem Alkylrest (C1 - C10), einem teilweise oder vollständig halogenierten Alkylrest (C1 - C10) und einem Alkyletherrest O-R^{E},
wobei die Reste R^{E} unabhängig voneinander ausgewählt sind aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren, wobei Li[Al*t*Bu₄] und Li[Al(CH₂SiMe₃)₄] ausgenommen sind.

2. Lithiumalkylaluminate gemäß der allgemeinen Formel Li[AlR₄] (I) nach Anspruch 1, wobei R ausgewählt ist aus der Gruppe bestehend aus Me, Et, *n*Pr, *i*Pr, nBu, *t*Bu, sBu, *i*Bu, CH(Me)(*i*Pr), CH(Me)(*n*Pr), CH(Et)₂, CH(Et)(Me)₂, CH₂C₆H₅, C₆H₅, CH₂SiMe₃, CH₂SiEt₃, CH₂Si(Me)₂(OMe), CH₂Si(Et)₂(OEt), CH₂Si(Me)(tBu)(OMe), CH₂Si(*t*Bu)(C₆H₅)(O*t*Bu) und CH₂Si(*i*Pr)₂(O*i*Pr).

3. Verwendung eines Lithiumalkylaluminats gemäß der allgemeinen Formel
Li[AlR₄] (I),
als Transferreagenz zur Übertragung wenigstens eines Restes R,
wobei
R ausgewählt ist aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
wobei
- R^{A} ausgewählt ist aus der Gruppe bestehend aus einem Alkylenrest (C1 - C6) und einem teilweise oder vollständig halogenierten Alkylenrest (C1 - C6),
- die Reste R^{B} unabhängig voneinander ausgewählt sind aus der Gruppe bestehend aus einem Alkylrest (C1 - C10), einem teilweise oder vollständig halogenierten Alkylrest (C1 - C10) und einem Alkyletherrest O-R^{E},
wobei die Reste R^{E} unabhängig voneinander ausgewählt sind aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren.

4. Verfahren zur Übertragung wenigstens eines Restes R auf eine Verbindung gemäß der allgemeinen Formel E(X)_{q} zur Herstellung einer Verbindung gemäß der allgemeinen Formel
E(X)_{q-p}Rₚ (II)
wobei
R ausgewählt ist aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
wobei
- R^{A} ausgewählt ist aus der Gruppe bestehend aus einem Alkylenrest (C1 - C6) und einem teilweise oder vollständig halogenierten Alkylenrest (C1 - C6),
- die Reste R^{B} unabhängig voneinander ausgewählt sind aus der Gruppe bestehend aus einem Alkylrest (C1 - C10), einem teilweise oder vollständig halogenierten Alkylrest (C1 - C10) und einem Alkyletherrest O-R^{E},
wobei die Reste R^{E} unabhängig voneinander ausgewählt sind aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
- E ausgewählt ist aus der Gruppe bestehend aus Aluminium, Gallium, Indium, Thallium, Germanium, Zinn, Blei, Antimon, Bismut, Zink, Cadmium, Quecksilber und Phosphor,
- X = Halogen,
- q = 2, 3 oder 4,
und
- p = 1, 2, 3 oder 4,
unter Verwendung eines Lithiumalkylaluminats gemäß der allgemeinen Formel Li[AlR₄] (I),
wobei
R ausgewählt ist aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
wobei
- R^{A} ausgewählt ist aus der Gruppe bestehend aus einem Alkylenrest (C1 - C6) und einem teilweise oder vollständig halogenierten Alkylenrest (C1 - C6),
- die Reste R^{B} unabhängig voneinander ausgewählt sind aus der Gruppe bestehend aus einem Alkylrest (C1 - C10), einem teilweise oder vollständig halogenierten Alkylrest (C1 - C10) und einem Alkyletherrest O-R^{E},
wobei die Reste R^{E} unabhängig voneinander ausgewählt sind aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
umfassend die Schritte:
a) Zurverfügungstellung des Lithiumalkylaluminats gemäß der allgemeinen Formel Li[AlR₄] (I),
und
b) Umsetzung von E(X)_{q} mit dem Lithiumalkylaluminat Li[AlR₄] (I) in wenigstens einem aprotischen Lösungsmittel in einem Reaktionsgefäß.

5. Verfahren nach Anspruch 4, wobei R ausgewählt ist aus der Gruppe bestehend aus Me, Et, *n*Pr, *i*Pr, *n*Bu, *t*Bu, sBu, *i*Bu, CH(Me)(*i*Pr), CH(Me)(*n*Pr), CH(Et)₂, CH(Et)(Me)₂, CH₂C₆H₅, C₆H₅, CH₂SiMe₃, CH₂SiEt₃, CH₂Si(Me)₂(OMe), CH₂Si(Et)₂(OEt), CH₂Si(Me)(*t*Bu)(OMe), CH₂Si(*t*Bu)(C₆H₅)(O*t*Bu) und CH₂Si(*i*Pr)₂(O*i*Pr).

6. Verfahren nach Anspruch 4 oder 5, wobei X = F, Cl oder Br.

7. Verfahren nach einem der Ansprüche 4 bis 6, wobei die Umsetzung von E(X)_{q} mit dem Lithiumalkylaluminat Li[AlR₄] (I) folgende Schritte umfasst:
i) Bereitstellen einer Lösung von E(X)_{q} in einem ersten Lösungsmittel,
ii) Hinzufügen des Lithiumalkylaluminats Li[AlR₄] (I),
wobei während des Hinzufügens und/oder nach dem Hinzufügen von Li[AlR₄] (I) eine Reaktion von E(X)_{q} mit Li[AlR₄] (I) erfolgt.

8. Verfahren nach Anspruch 7, wobei Li[AlR₄] (I) in einem zweiten Lösungsmittel suspendiert oder gelöst hinzugefügt wird.

9. Verfahren nach Anspruch 8, wobei das zweite Lösungsmittel mit dem ersten Lösungsmittel mischbar oder identisch ist.

10. Verfahren nach Anspruch 8 oder 9, wobei das erste Lösungsmittel und das zweite Lösungsmittel unabhängig voneinander ausgewählt sind aus der Gruppe bestehend aus Kohlenwasserstoffen, Benzol und Benzolderivaten.

11. Verfahren nach einem der Ansprüche 4 bis 10, wobei die Umsetzung von E(X)_{q} mit dem Lithiumalkylaluminat Li[AlR₄] (I) bei einer Innentemperatur T_{W} des Reaktionsgefäßes durchgeführt wird, wobei die Innentemperatur T_{W} zwischen -50 °C und 100 °C beträgt.

12. Verfahren nach einem der Ansprüche 7 bis 11, wobei eine Innentemperatur T_{K} des Reaktionsgefäßes während des Hinzufügens und/oder nach dem Hinzufügen von Li[AlR₄] (I) zwischen -60 °C und 50 °C beträgt.

13. Verfahren nach einem der Ansprüche 4 bis 13, wobei nach dem Schritt, umfassend die Umsetzung von E(X)_{q} mit Li[AlR₄] (I), ein weiterer Schritt durchgeführt wird, welcher eine Isolierung von E(X)_{q-p}Rₚ (II) umfasst.

14. Verbindungen gemäß der allgemeinen Formel E(X)_{q-p}Rₚ (II),
erhältlich nach einem Verfahren gemäß einem der Ansprüche 4 bis 13.

15. Verbindungen nach Anspruch 14, wobei die Verbindungen isomerenrein vorliegen.

16. Verwendung einer Verbindung E(X)₂R,
wobei
R ausgewählt ist aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
wobei
- R^{A} ausgewählt ist aus der Gruppe bestehend aus einem Alkylenrest (C1 - C6) und einem teilweise oder vollständig halogenierten Alkylenrest (C1 - C6),
- die Reste R^{B} unabhängig voneinander ausgewählt sind aus der Gruppe bestehend aus einem Alkylrest (C1 - C10), einem teilweise oder vollständig halogenierten Alkylrest (C1 - C10) und einem Alkyletherrest O-R^{E},
wobei die Reste R^{E} unabhängig voneinander ausgewählt sind aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
- E ausgewählt ist aus der Gruppe bestehend aus Phosphor, Antimon und Bismuth und
- X = Halogen,
▪ erhältlich nach einem Verfahren gemäß einem der Ansprüche 4 bis 13,
▪ erhalten nach einem Verfahren gemäß einem der Ansprüche 4 bis 13,
oder
▪ gemäß Anspruch 14 oder 15,
zur Herstellung einer Verbindung gemäß der allgemeinen Formel (R)EH₂ (III).

17. Verwendung einer Verbindung AlR₃,
wobei
R ausgewählt ist aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
wobei
- R^{A} ausgewählt ist aus der Gruppe bestehend aus einem Alkylenrest (C1 - C6) und einem teilweise oder vollständig halogenierten Alkylenrest (C1 - C6),
- die Reste R^{B} unabhängig voneinander ausgewählt sind aus der Gruppe bestehend aus einem Alkylrest (C1 - C10), einem teilweise oder vollständig halogenierten Alkylrest (C1 - C10) und einem Alkyletherrest O-R^{E},
wobei die Reste R^{E} unabhängig voneinander ausgewählt sind aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
▪ erhältlich nach einem Verfahren gemäß einem der Ansprüche 4 bis 13,
▪ erhalten nach einem Verfahren gemäß einem der Ansprüche 4 bis 13,
oder
▪ gemäß Anspruch 14 oder 15,
als eine Präkursorverbindung zur Herstellung einer Aluminiumschicht oder einer Aluminium enthaltenden Schicht auf einer Oberfläche eines Substrats.

18. Verfahren zur Herstellung von Lithiumalkylaluminaten
gemäß der allgemeinen Formel
Li[AlR₄] (I)
wobei
R ausgewählt ist aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
wobei
- R^{A} ausgewählt ist aus der Gruppe bestehend aus einem Alkylenrest (C1 - C6) und einem teilweise oder vollständig halogenierten Alkylenrest (C1 - C6),
- die Reste R^{B} unabhängig voneinander ausgewählt sind aus der Gruppe bestehend aus einem Alkylrest (C1 - C10), einem teilweise oder vollständig halogenierten Alkylrest (C1 - C10) und einem Alkyletherrest O-R^{E},
wobei die Reste R^{E} unabhängig voneinander ausgewählt sind aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
umfassend den Schritt:
Umsetzung von LiAIH₄ mit einer Verbindung gemäß der allgemeinen Formel RLi,
wobei
R ausgewählt ist aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
wobei
- R^{A} ausgewählt ist aus der Gruppe bestehend aus einem Alkylenrest (C1 - C6) und einem teilweise oder vollständig halogenierten Alkylenrest (C1 - C6),
- die Reste R^{B} unabhängig voneinander ausgewählt sind aus der Gruppe bestehend aus einem Alkylrest (C1 - C10), einem teilweise oder vollständig halogenierten Alkylrest (C1 - C10) und einem Alkyletherrest O-R^{E},
wobei die Reste R^{E} unabhängig voneinander ausgewählt sind aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
in wenigstens einem aprotischen Lösungsmittel in einem Reaktionsbehältnis,
wobei ein molares Verhältnis LiAIH₄ : RLi ≥ 0,25 ist.

19. Verfahren nach Anspruch 18, wobei R ausgewählt ist aus der Gruppe bestehend aus Me, Et, *n*Pr, *i*Pr, *n*Bu, *t*Bu, sBu, *i*Bu, CH(Me)(*i*Pr), CH(Me)(*n*Pr), CH(Et)₂, CH(Et)(Me)₂, CH₂C₆H₅, C₆H₅, CH₂SiMe₃, CH₂SiEt₃, CH₂Si(Me)₂(OMe), CH₂Si(Et)₂(OEt), CH₂Si(Me)(*t*Bu)(OMe), CH₂Si(*t*Bu)(C₆H₅)(O*t*Bu) und CH₂Si(*i*Pr)2(O*i*Pr).

20. Verfahren nach Anspruch 18 oder 19, wobei die Umsetzung von LiAIH₄ mit der Verbindung RLi folgende Schritte umfasst:
i) Bereitstellen einer Lösung oder einer Suspension von LiAlH₄ in einem ersten Lösungsmittel S1,
ii) Hinzufügen der Verbindung RLi,
wobei während des Hinzufügens und/oder nach dem Hinzufügen von RLi eine Reaktion von LiAlH₄ mit der Verbindung RLi erfolgt.

21. Verfahren nach einem der Ansprüche 18 bis 20, wobei die Verbindung RLi in einem zweiten Lösungsmittel S2 suspendiert oder gelöst hinzugefügt wird.

22. Verfahren nach Anspruch 21, wobei das zweite Lösungsmittel S2 mit dem ersten Lösungsmittel S1 mischbar oder identisch ist.

23. Verfahren nach Anspruch 21 oder 22, wobei das erste Lösungsmittel S1 und das zweite Lösungsmittel S2 unabhängig voneinander ausgewählt sind aus der Gruppe bestehend aus Kohlenwasserstoffen, Benzol und Benzolderivaten.

24. Verfahren nach einem der Ansprüche 18 bis 23, wobei die Umsetzung von LiAlH₄ mit der Verbindung RLi bei einer Innentemperatur T_{U} des Reaktionsbehältnisses durchgeführt wird, wobei die Innentemperatur T_{U} zwischen -30 °C und 100 °C beträgt.

25. Verfahren nach einem der Ansprüche 20 bis 24, wobei eine Innentemperatur T_{H} des Reaktionsbehältnisses während des Hinzufügens und/oder nach dem Hinzufügen der Verbindung RLi zwischen -40 °C und 80 °C beträgt.

26. Verfahren nach einem der Ansprüche 18 bis 25, wobei nach dem Schritt, umfassend die Umsetzung von LiAlH₄ mit der Verbindung RLi, ein weiterer Schritt durchgeführt wird, welcher eine Isolierung von Li[AlR₄] umfasst:
i) als Lösung,
welche Li[AlR₄] (I) und das wenigstens eine aprotische Lösungsmittel umfasst,
oder
ii) als Feststoff.

27. Verfahren nach einem der Ansprüche 18 bis 26, wobei die Isolierung einen Filtrationsschritt umfasst.

28. Lösung, umfassend
- ein Lithiumalkylaluminat gemäß der allgemeinen Formel
Li[AlR₄] (I)
und
- wenigstens ein aprotisches Lösungsmittel,
erhältlich nach einem Verfahren gemäß einem der Ansprüche 18 bis 27,

29. Lithiumalkylaluminate gemäß der allgemeinen Formel
Li[AlR₄] (I),
erhältlich nach einem Verfahren gemäß einem der Ansprüche 18 bis 27.

30. Verwendung
a) eines Lithiumalkylaluminats gemäß der allgemeinen Formel Li[AlR₄] (I),
oder
b) einer Lösung,
umfassend ein Lithiumalkylaluminat gemäß der allgemeinen Formel Li[AlR₄] (I) und wenigstens ein aprotisches Lösungsmittel,
▪ erhalten nach einem Verfahren gemäß einem der Ansprüche 18 bis 27,
▪ erhältlich nach einem Verfahren gemäß einem der Ansprüche 18 bis 27,
oder
▪ gemäß Anspruch 28 oder 29,
als Transferreagenz zur Übertragung wenigstens einer Gruppe R.

31. Verwendung eines Lithiumalkylaluminats gemäß der allgemeinen Formel
Li[AlR₄] (I),
▪ erhalten nach einem Verfahren gemäß einem der Ansprüche 18 bis 17,
▪ erhältlich nach einem Verfahren gemäß einem der Ansprüche 18 bis 27,
oder
▪ gemäß Anspruch 28 oder 29
zur Herstellung von Verbindungen gemäß der allgemeinen Formel
(R)EH₂ (III),
wobei
R ausgewählt ist aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
wobei
- R^{A} ausgewählt ist aus der Gruppe bestehend aus einem Alkylenrest (C1 - C6) und einem teilweise oder vollständig halogenierten Alkylenrest (C1 - C6),
- die Reste R^{B} unabhängig voneinander ausgewählt sind aus der Gruppe bestehend aus einem Alkylrest (C1 - C10), einem teilweise oder vollständig halogenierten Alkylrest (C1 - C10) und einem Alkyletherrest O-R^{E},
wobei die Reste R^{E} unabhängig voneinander ausgewählt sind aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren
und
- E ausgewählt ist aus der Gruppe bestehend aus Phosphor, Antimon und Bismuth.

32. Verfahren zur Herstellung von Verbindungen gemäß der allgemeinen Formel
(R)EH₂ (III),
unter Verwendung
eines Lithiumalkylaluminats gemäß der allgemeinen Formel Li[AlR₄] (I),
wobei
R ausgewählt ist aus der Gruppe bestehend aus einem Alkylrest (C1 - C10), einem teilweise oder vollständig halogenierten Alkylrest (C1 - C10), einem (Trialkylsilyl)alkylrest R^{A}-Si(R^{B})₃, einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
wobei
- R^{A} ausgewählt ist aus der Gruppe bestehend aus einem Alkylenrest (C1 - C6) und einem teilweise oder vollständig halogenierten Alkylenrest (C1 - C6),
- die Reste R^{B} unabhängig voneinander ausgewählt sind aus der Gruppe bestehend aus einem Alkylrest (C1 - C10), einem teilweise oder vollständig halogenierten Alkylrest (C1 - C10) und einem Alkyletherrest O-R^{E},
wobei die Reste R^{E} unabhängig voneinander ausgewählt sind aus der Gruppe bestehend aus einem Alkylrest (C1 - C10), einem teilweise oder vollständig halogenierten Alkylrest (C1 - C10), einem Benzylrest, einem teilweise oder vollständig substituierten Benzylrest, einem einkernigen oder mehrkernigen Aren, einem teilweise oder vollständig substituierten einkernigen oder mehrkernigen Aren, einem einkernigen oder mehrkernigen Heteroaren und einem teilweise oder vollständig substituierten einkernigen oder mehrkernigen Heteroaren,
umfassend die Schritte:
a) Zurverfügungstellung einer Lösung des Lithiumalkylaluminats gemäß der allgemeinen Formel Li[AlR₄] (I) in wenigstens einem aprotischen Lösungsmittel,
b) Umsetzung der Lösung aus Schritt a) mit einer Verbindung EX₃ in einem Reaktionsbehältnis, wobei
- E ausgewählt ist aus der Gruppe bestehend aus Phosphor, Antimon und Bismuth
und
- X = Halogen,
und
c) Hinzufügen einer Lösung oder einer Suspension umfassend ein hydridisches Reduktionsmittel in einem aprotischen Lösungsmittel Sz,
wobei
- ein molares Verhältnis EX₃ : Li[AlR₄] (I) ≥ 4 ist
und
- ein molares Verhältnis EX₃ : Reduktionsmittel ≤ 1 ist.

33. Verfahren nach Anspruch 32, wobei das hydridische Reduktionsmittel *in situ* hergestellt wird durch eine Reaktion von NaAlH₄ mit einem Glycolether,
wobei ein molares Verhältnis NaAlH₄ : Glycolether 0,5 beträgt.

34. Verfahren nach Anspruch 33, wobei der Glycolether ausgewählt ist aus der Gruppe bestehend aus einem Monoethylenglycolmonoether, einem Diethylenglycolmonoether, einem Triethylengylcolmonoether, einem Monopropylenglycolmonoether, einem Dipropylenglycolmonoether und einem Tripropylenglycolmonoether.

35. Verbindungen gemäß der allgemeinen Formel
(R)EH₂ (III),
erhältlich nach einem Verfahren gemäß einem der Ansprüche 32 bis 34.
